# EUROPÄISCHE PATENTANMELDUNG

(11) **EP 3 772 092 A1**
(43) Veröffentlichungstag der Anmeldung: **03.02.2021**
(21) Anmeldenummer: 20188394.9
(22) Anmeldetag: 29.07.2020
(51) Int. Cl.: H01L 21/822, H01L 27/06, H01L 23/48

(54) **HALBLEITER-BAUELEMENTSTRUKTUR MIT VERBINDUNGSHALBLEITER UND VERFAHREN ZUM HERSTELLEN DERSELBIGEN**

(30) Priorität: 31.07.2019 DE 102019211465
(71) Anmelder: FRAUNHOFER-GESELLSCHAFT zur Förderung der angewandten Forschung e.V., 80686 München (DE)
(72) Erfinder: KLUMPP, Armin, 80686 München (DE)
(74) Vertreter: Stöckeler, Ferdinand

(57) **Zusammenfassung**

Die Erfindung betrifft eine Halbleiter-Bauelementstruktur (100), aufweisend ein Substrat (10) mit einer auf einer ersten Substratseite (1) gelegenen ersten Hauptoberfläche (11) und einer auf einer gegenüberliegenden zweiten Substratseite (2) gelegenen zweiten Hauptoberfläche (12), sowie eine vertikale Durchkontaktierung (13), die sich zwischen der ersten Hauptoberfläche (11) und der zweiten Hauptoberfläche (12) vollständig durch das Substrat (10) hindurch erstreckt. Auf der ersten Substratseite (1) ist im Bereich der Durchkontaktierung (13) eine Metallisierungsschicht (31) angeordnet, die galvanisch mit der Durchkontaktierung (13) verbunden ist. Auf der Metallisierungsschicht (31) ist eine mit der Metallisierungsschicht (31) galvanisch verbundene Verbindungshalbleiter-Schicht (21) angeordnet. Die Erfindung betrifft ferner ein Verfahren zum Herstellen einer derartigen Halbleiter-Bauelementstruktur (100).

## Beschreibung

Die Erfindung betrifft eine Halbleiter-Bauelementstruktur mit einem Verbindungshalbleiter, ein dreidimensionales Halbleiter-Bauelement mit einer solchen Halbleiter-Bauelementstruktur, und ein Verfahren zum Herstellen einer solchen Halbleiter-Bauelementstruktur.

Die vorliegende Erfindung kann besonders vorteilhaft im Bereich der SD-Systemintegration eingesetzt werden. Unter dreidimensionaler Integration versteht man die vertikale Verbindung (mechanisch und elektrisch) von Bauelementen, die mittels Planartechnik hergestellt wurden. Letztere werden auch als zweidimensionale bzw. 2D-Systeme bezeichnet, da die Schaltungsstrukturen in einer waagerechten bzw. horizontalen zweidimensionalen Ebene (auch als waagerechte bzw. horizontale Haupt-Substratebene bezeichnet) angeordnet sind. Mindestens zwei übereinander angeordnete, in konventioneller Planartechnik hergestellte, zweidimensionale Systeme können dann wiederum vertikal miteinander verbunden werden, um so ein 3D-System zu bilden. Die vertikale Richtung bezieht sich hierbei auf die oben genannte waagerechte bzw. horizontale zweidimensionale Ebene des jeweiligen 2D-Systems bzw. auf die sich planar (horizontal) über das jeweilige Substrat erstreckenden Bauelementstrukturen, wie z.B. integrierte Schaltkreise oder dotierte Regionen, wobei die vertikale Richtung im Wesentlichen senkrecht zur waagerechten bzw. horizontalen Ebene verläuft. Ein 3D-System (vertikal und horizontal) kann demnach mindestens zwei oder mehrere vertikal übereinander angeordnete 2D-Systeme (horizontal) aufweisen.

Bei den 3D-Systemen wird im Wesentlichen in zwei Hauptgruppen unterschieden. Beim sogenannten 3D-Packaging werden zwei oder mehr eigenständige Baugruppen, wie zum Beispiel Chips oder Dies, vertikal übereinander gestapelt und in einem dreidimensional angeordneten Package integriert. Die einzelnen Baugruppen werden untereinander mittels vertikaler Durchkontaktierungen verbunden. Hierbei werden die Schaltkreise der einzelnen Chips nicht in einem einzigen gemeinsamen Schaltkreis integriert. Sie kommunizieren weiterhin außerhalb des Chips über elektrische Signale, genauso als wenn sie in unterschiedlichen Gehäusen auf eine Leiterplatte montiert wären. Bei den sogenannten 3D-ICs (IC - engl.: Integrated Circuit) hingegen werden mehrere Komponenten eines gemeinsamen Schaltkreises vertikal übereinander angeordnet und mittels der vertikalen Durchkontaktierungen zu einem einzigen gemeinsamen Schaltkreis verbunden. Das heißt, ein 3D-IC wirkt wie ein einzelner IC. Alle Komponenten auf allen Chip-Ebenen kommunizieren innerhalb des 3D-ICs miteinander, je nachdem wie er entworfen wurde, sowohl vertikal als auch horizontal.

Wenn im Sinne der vorliegenden Offenbarung von einer dreidimensionalen Systemintegration, einem 3D-System, einem dreidimensionalen Halbleiterbauelement und dergleichen die Rede ist, dann sind damit stets beide oben genannten Hauptgruppen gemeint.

Die Vorteile eines dreidimensional integrierten mikroelektronischen Systems sind u.a. die bei gleichen Designregeln erreichbaren höheren Packungsdichten und Schaltgeschwindigkeiten gegenüber, konventionell in Planartechnik gefertigten, zweidimensionalen Systemen. Diese höheren Schaltgeschwindigkeiten sind zum einen bedingt durch kürzere Leitungswege zwischen den einzelnen Bauelementen oder Schaltungen, zum anderen durch die Möglichkeit der parallelen Informationsverarbeitung.

3D-Systeme haben zudem den Vorteil, dass bei einer Erhöhung der Integrationsdichte der Footprint des Bauelements im Vergleich zu 2D-Systemen gering gehalten werden kann, da bei einem 2D-System die Integrationsdichteerhöhung zu mehr Platzbedarf in lateraler (bzw. horizontaler) Richtung führt, während hingegen bei einem 3D-System der zusätzlich zur Verfügung stehende Raum in vertikaler Richtung genutzt wird.

Dies kann insbesondere bei neuromorphen bzw. neuronalen Netzen vorteilhaft sein, wo eine Ausdehnung in lateraler Richtung aus limitierten Platzgründen unerwünscht ist. Zudem sind gerade in derartigen Anwendungen schnelle Schaltgeschwindigkeiten sowie eine geringe Leistungsaufnahme erwünscht. Dies ist mit einem 3D-System deutlich besser realisierbar als mit herkömmlichen 2D-Systemen. Eine minimale Leistungsaufnahme kann in einem 3D-System beispielsweise auch durch minimale Leiterbahnstrecken aufgrund dem Wegfall von Signaltreibern ermöglicht werden.

Die für nicht-silizium-basierte neuronale Netze notwendigen Materialien und/oder Herstellungstechnologien sind überwiegend nicht CMOS-kompatibel. Zum Einsatz kommen nach aktuellem Stand der Wissenschaft Edelmetalle aller Art wie Gold, Platin, Palladium aber auch unedleres wie Molybdän, Kupfer, Titan oder Wolfram. Die Herstellungstemperaturen (bis 800°C) der zur Emulation von Synapsen und Neuronen notwendigen Bauelemente wie Memristoren oder MemTransistoren liegen zum Teil über der maximal zulässigen Temperatur von fertig prozessierten CMOS-Schaltungen (bis 450°C). Daher ist eine Herstellung getrennt von der CMOS-Prozessierung notwendig. Vorteilhaft ist aber die räumliche Nähe der neuronalen Bauelemente bzw. Netzwerke zu den CMOS- oder Analog-Chips, da die Signale auch weiterverarbeitet oder aufbereitet werden müssen.

Die bisherigen Ansätze bewegen sich ausschließlich im Rahmen der CMOS-Technologien für Silizium als Halbleiter. Der Anmelderin ist derzeit jedoch keine Lösung für das damit verbundene, oben beschriebene, Problem bekannt. Die Siliziumstrukturen werden im Stand der Technik senkrecht aufgebaut (FinFETs mit Siliziumtechnologie) um den kleinen Footprint zu ermöglichen, aber auch um die sogenannte fully-depletion als elektronischen Effekt zu nutzen. Bei FinFETs werden zunächst Finnen in ein Siliziumsubstrat geätzt, und anschließend wird mittels eines LPCVD-Prozesses ein stark dotiertes Polysilizium auf die Finnen abgeschieden. Somit entsteht eine dreidimensionale Struktur, die z.B. als Transistor genutzt werden kann. Die weitere Integration dieser dreidimensionalen Struktur in ein 3D-System erfolgt immer mittels Durchkontaktierungen, die indirekt über eigene Metall-Leiterbahnebenen des Chips mit dem dotierten Bereich eines Bauelements verbunden sind.

Aufgrund seiner elektrischen Eigenschaften wäre einkristallines Silizium dem polykristallinen Silizium zwar eigentlich zu bevorzugen. Allerdings müsste bei der Prozessführung zum Abscheiden von einkristallinem Silizium die Temperatur bis zur Schmelztemperatur von Silizium erhöht werden, was aber zwangsläufig dazu führen würde, das darunterliegende Bauteilstrukturen, und insbesondere in CMOS-Technik gefertigte Strukturen, irreparabel geschädigt werden würden.

Es ist daher eine Aufgabe der vorliegenden Erfindung, eine Alternative zu Silizium-basierten Bauelementstrukturen bereitzustellen, die als Bestandteil zur Herstellung eines 3D-Systems verwendet werden können. Außerdem wäre es wünschenswert ein Verfahren zur Herstellung einer derartigen alternativen Bauelementstruktur bereitzustellen, welches die mit den Silizium-basierten Herstellungstechniken verbundenen Probleme nicht oder in deutlich abgemilderter Form aufweist.

Zur Lösung dieser Aufgabe werden eine Halbleiter-Bauelementstruktur mit den Merkmalen von Anspruch 1 sowie ein Verfahren zum Herstellen derselbigen mit den Merkmalen von Anspruch 14 vorgeschlagen. Ausführungsformen und weitere vorteilhafte Aspekte sind in den jeweils abhängigen Patentansprüchen genannt.

Die erfindungsgemäße Halbleiter-Bauelementstruktur weist ein Substrat mit einer auf einer ersten Substratseite gelegenen ersten Hauptoberfläche und einer auf einer gegenüberliegenden zweiten Substratseite gelegenen zweiten Hauptoberfläche auf. Auf der ersten Hauptoberfläche ist ein planarer Schichtstapel angeordnet. Das Substrat kann beispielsweise ein leitendes Substrat, ein nicht-leitendes Substrat oder ein halbleitendes Substrat sein und kann beispielsweise Silizium, Glas oder Quarz aufweisen. Das Substrat weist eine vertikale Durchkontaktierung auf, die sich zwischen der ersten Hauptoberfläche und der zweiten Hauptoberfläche vollständig durch das Substrat hindurch erstreckt. Der planare Schichtstapel weist eine auf der ersten Substratseite im Bereich der Durchkontaktierung angeordnete Metallisierungsschicht auf, die galvanisch mit der Durchkontaktierung verbunden ist. Der planare Schichtstapel weist ferner eine auf der Metallisierungsschicht angeordnete und mit der Metallisierungsschicht galvanisch verbundene Verbindungshalbleiter-Schicht auf. Die Verbindungshalbleiter-Schicht weist mindestens einen auf der Metallisierungsschicht angeordneten und mit der Metallisierungsschicht galvanisch verbundenen Verbindungshalbleiter auf. Die Verbindungshalbleiter-Schicht kann direkt und unmittelbar auf der Metallisierungsschicht angeordnet sein. Die Metallisierungsschicht und die darüber bzw. darauf angeordnete Verbindungshalbleiter-Schicht bilden einen horizontalen bzw. planaren Schichtstapel auf der ersten Hauptoberfläche des Substrats, wobei sich die einzelnen Schichten des Schichtstapels horizontal bzw. waagerecht und im Wesentlichen parallel zur ersten bzw. zweiten Hauptoberfläche des Substrats erstrecken können. Im Stand der Technik werden derartige Halbleiterbauelement-Strukturen primär in Siliziumtechnik gefertigt, das heißt es kommen keine Verbindungshalbleiter sondern elementare Halbleiter zum Einsatz. Im Falle von Silizium kann derzeit jedoch höchstens polykristallines Silizium auf der Metallisierungsschicht abgeschieden werden, denn zum Erzeugen von einkristallinem Silizium müsste in der Prozessführung über die Schmelztemperatur von Silizium erhitzt werden, was jedoch zur Zerstörung der darunterliegenden Schichten, wie zum Beispiel der Metallisierungsschicht, führen würde. Bei der erfindungsgemäßen Erzeugung des Schichtstapels mit einem Verbindungshalbleiter bleibt hingegen die Metallisierungsschicht intakt. Darüber hinaus kann der Verbindungshalbleiter eine direkte Bandlücke aufweisen, während hingegen Elementhalbleiter wie Silizium meist eine indirekte Bandlücke aufweisen. Die direkte Bandlücke führt zu deutlich besseren elektrischen Eigenschaften des Halbleiters, weshalb der erfindungsgemäße Verbindungshalbleiter den bisher zum Einsatz kommenden Elementhalbleitern (z.B. Silizium) zu bevorzugen ist.

Gemäß einem Ausführungsbeispiel kann die Verbindungshalbleiter-Schicht einen monokristallinen Verbindungs-Halbleiter aufweisen. Monokristalline bzw. einkristalline Verbindungs-Halbleiter weisen im Vergleich zu polykristallinen Strukturen besonders gute elektrische Eigenschaften auf. Daher wäre in den bisherigen Silizium-basierten Verfahren der Einsatz von monokristallinem Silizium bevorzugt. Wie eingangs erwähnt, kann heutzutage allerdings aufgrund der verfügbaren Prozesse höchstens polykristallines Silizium direkt auf einer Metallisierungsschicht abgeschieden werden, damit diese nicht irreparabel geschädigt wird. Die hierin beschriebene Erfindung ermöglicht es, einkristallines Verbindungshalbleiter-Material direkt auf der Metallisierungsschicht anzuordnen. Zu einkristallinem Verbindungshalbleiter-Material zählen auch Einkristalle aus mehr oder weniger komplexen chemischen Verbindungen.

Gemäß einem weiteren Ausführungsbeispiel kann die Verbindungshalbleiter-Schicht mindestens ein 2D-Verbundmaterial aufweisen. Ein 2D-Verbundmaterial ist nicht zu verwechseln mit den ebenfalls hierin beschriebenen 2D-Systemen. 2D-Materialien, die gelegentlich auch als Single Layer oder Monolayer Materialien bezeichnet werden, sind kristalline Materialien, die lediglich eine einzelne Atomlage aufweisen. Mehrere dieser Monolayer können übereinander gestapelt werden. 2D-Materialien haben die Eigenschaft, dass diese einkristallin abgeschieden bzw. umgesetzt werden. Aufgrund ungewöhnlicher Eigenschaften sind sie Gegenstand umfangreicher (Grundlagen-)Forschungen. Allgemein können 2D-Materialien entweder als zweidimensionale Allotrope unterschiedlicher Elemente oder als Verbindung verschiedener Elemente mit kovalenter Bindung, sogenannte 2D-Verbundmaterialien, angesehen werden. Ein bekannter Vertreter eines allotropen 2D-Materials ist beispielsweise Graphen. Als nicht-limitierende und nicht abschließende Beispiele für 2D-Verbundmaterialien können u.a. Graphan, Boronitren, Germaniumphosphid und Molybdän(IV)-sulfid genannt werden. Im Folgenden sollen insbesondere die Verbindungen verschiedener Elemente, d.h. 2D-Verbundmaterialien, und hierbei insbesondere Verbindungshalbleiter, betrachtet werden. Die effiziente Integration von 2D-Materialien in 3D-Systemen stellt nach wie vor eine außerordentliche Herausforderung sowie einen limitierenden Faktor bei der Gesamtleistung des Systems und beim Schaltungsdesign dar.

Gemäß einem weiteren Ausführungsbeispiel kann die Verbindungshalbleiter-Schicht mindestens ein Material aus der Gruppe der Übergangsmetall-Chalkogenide aufweisen. Das heißt, die Verbindungshalbleiter-Schicht kann eine Elementkombination aus der Gruppe der Übergangsmetalle und der Gruppe der Chalkogeniden aufweisen. Übergangsmetall-Chalkogenide werden auch als TMDs (engl.: Transition Metal Dichalcogenides) bezeichnet. TMDs sind in der Regel aus drei atomaren Ebenen aufgebaut und beinhalten meist zwei verschiedene atomare Spezies, nämlich ein Metall und zwei Chalkogenide. Die auch als TMD-Monolayer bezeichneten Übergangsmetall-Chalkogenide sind atomar dünne Halbleiter vom Typ MX₂, wobei M ein Übergangsmetall-Atom (z.B. Mo, W, etc.) bezeichnet und X ein Chalkogenid-Atom (z.B. S, Se oder Te) bezeichnet. Dabei ist in der Regel eine Lage von M-Atomen zwischen zwei Lagen von X-Atomen angeordnet. Diese Anordnungen zählen zu der übergeordneten Gruppe von 2D-Matierialien. TMD Monolayer, wie zum Beispiel MoS₂, WS₂, MoSe₂, WSe₂, MoTe₂ haben eine direkte Bandlücke, was sie für die Verwendung als Verbindungshalbleiter in der erfindungsgemäßen Verbindungshalbleiter-Schicht auszeichnet.

Gemäß einem weiteren Ausführungsbeispiel kann die Verbindungshalbleiter-Schicht Molybdändisulfid MoS₂ aufweisen. Molybdändisulfid eignet sich aufgrund seiner elektrischen Eigenschaften besonders gut als Verbindungshalbleiter in der erfindungsgemäßen Verbindungshalbleiter-Schicht. Zudem weist ein MoS₂ Monolayer eine Dicke von gerade einmal 6.5 Å auf.

Gemäß einem weiteren Ausführungsbeispiel kann die Metallisierungsschicht direkt auf der ersten Hauptoberfläche des Substrats angeordnet sein. Dies eignet sich beispielsweise dann, wenn das Substrat keine elektrisch leitende Eigenschaft aufweist. Alternativ dazu, das heißt, falls das Substrat elektrisch leitende Eigenschaften aufweist, kann auf der ersten Substratseite eine elektrisch isolierende Schicht zwischen der ersten Hauptoberfläche des Substrats und der Metallisierungsschicht angeordnet sein.

Gemäß einem weiteren Ausführungsbeispiel kann die Verbindungshalbleiter-Schicht mittels Abscheidung auf der Metallisierungsschicht angeordnet sein. Dabei kann die Verbindungshalbleiter-Schicht direkt auf der Metallisierungsschicht abgeschieden werden. Das Abscheiden des Verbindungshalbleitermaterials stellt eine einfache und verhältnismäßig kostengünstige Möglichkeit dar, um die Verbindungshalbleiter-Schicht auf der Metallisierungsschicht anzuordnen.

Gemäß einem alternativen Ausführungsbeispiel kann die Verbindungshalbleiter-Schicht mittels chemischer Umsetzung aus zumindest einem Teil der Metallisierungsschicht gebildet sein. Alternativ oder zusätzlich kann die Verbindungshalbleiter-Schicht mittels chemischer Umsetzung aus zumindest einem Teil einer auf der Metallisierungsschicht abgeschiedenen weiteren Schicht (z.B. einer weiteren Metallisierungsschicht) gebildet sein. Unter der chemischen Umsetzung versteht man ein neuartiges Verfahren, das sich von den eingangs erwähnten Abscheideverfahren unterscheidet. Bei der chemischen Umsetzung werden sozusagen Teile einer Ausgangsschicht durch chemische Reaktionen in die Verbindungs-halbleiter-Schicht umgewandelt. Als Ausgangsschicht kann die Metallisierungsschicht, oder eine weitere Schicht, dienen. Bevorzugt handelt es sich bei der Ausgangsschicht um eine Metallisierungsschicht, und insbesondere um eine Übergangsmetallschicht, wie zum Beispiel Molybdän. Dieses kann beispielsweise mittels geeigneter Reaktionspartner, wie zum Beispiel Schwefel, umgesetzt werden. Bei dieser chemischen Umsetzung entsteht aus zumindest einem Teil der Ausgangsschicht eine Verbindungshalbleiter-Schicht aus einem 2D-Material, die einen TMD Monolayer aufweist, in diesem Falle MoS₂.

Gemäß einem weiteren Ausführungsbeispiel kann die Halbleiter-Bauelementstruktur ferner eine auf der Verbindungshalbleiter-Schicht angeordnete und mit der Verbindungshalbleiter-Schicht galvanisch verbundene zweite Verbindungshalbleiter-Schicht aufweisen. Mittels dieser Anordnung kann beispielsweise eine Diodenstruktur erzeugt werden.

Gemäß einem weiteren Ausführungsbeispiel kann die zweite Verbindungshalbleiter-Schicht mindestens ein 2D-Verbundmaterial aufweisen. Die zweite Verbindungshalbleiter-Schicht kann demnach beispielsweise, ebenso wie die oben erwähnte (erste) Verbindungshalbleiter-Schicht, mindestens ein Material aus der Gruppe der Übergangsmetall-Chalkogenide, und insbesondere MoS₂ aufweisen.

Gemäß einem weiteren Ausführungsbeispiel kann die Halbleiter-Bauelementstruktur ferner eine auf der zweiten Verbindungshalbleiter-Schicht angeordnete und mit der zweiten Verbindungshalbleiter-Schicht galvanisch verbundene dritte Verbindungshalbleiter-Schicht aufweisen. Mittels dieser Anordnung kann beispielsweise eine Transistorstruktur erzeugt werden.

Gemäß einem weiteren Ausführungsbeispiel kann die dritte Verbindungshalbleiter-Schicht mindestens ein 2D-Verbundmaterial aufweisen. Die dritte Verbindungshalbleiter-Schicht kann demnach beispielsweise, ebenso wie die oben erwähnte (erste) Verbindungshalbleiter-Schicht und/oder die zweite Verbindungshalbleiter-Schicht, mindestens ein Material aus der Gruppe der Übergangsmetall-Chalkogenide, und insbesondere MoS₂ aufweisen.

Gemäß einem weiteren Ausführungsbeispiel kann auf der ersten und/oder zweiten Substratseite ein galvanisch mit der vertikalen Durchkontaktierung verbundener Kontaktierungsabschnitt angeordnet sein, wobei die Halbleiter-Bauelementstruktur mittels diesem Kontaktierungsabschnitt galvanisch und/oder mechanisch mit einer zusätzlichen separaten elektronischen Bauelementstruktur verbindbar ist, um ein dreidimensionales elektronisches Halbleiter-Bauelement zu erzeugen, bei dem die Halbleiter-Bauelementstruktur und die zusätzliche separate elektronische Bauelementstruktur vertikal übereinander angeordnet sind. Mit der erfindungsgemäßen Halbleiter-Bauelementstruktur kann also ein dreidimensionales elektronisches Halbleiter-Bauelement (3D-System) hergestellt werden, indem gegenüberliegend von der ersten und/oder der zweiten Substratseite eine zusätzliche separate elektronische Bauelementstruktur angeordnet sein kann, die mittels einem Kontaktierungsabschnitt mechanisch und/oder galvanisch mit der Halbleiter-Bauelementstruktur, und insbesondere mit der Verbindungshalbleiter-Schicht, verbunden ist. Bei der separaten elektronischen Bauelementstruktur kann es sich beispielsweise um ein in Planartechnik gefertigtes zweidimensionales System oder um eine weitere erfindungsgemäße Halbleiter-Bauelementstruktur handeln. Das so herstellbare 3D-System kann ein 3D-Package oder ein 3D-IC sein.

Der planare Schichtstapel kann ein planares 2D-Bauelement aufweisen, ein planares 2D-Bauelement bilden oder als ein planares 2D-Bauelement ausgestaltet sein. Zur Definition eines 2D-Systems sei auf die obigen Ausführungen verwiesen. Das 2D-Bauelement stellt eine über eine reine Ladungsträgerleitung hinausgehende elektronische Funktionalität bereit. Dies unterscheidet das 2D-Bauelement beispielsweise von einer Durchkontaktierung (Via), die eine reine Ladungsträgerleitung darstellt.

Die Erfindung betrifft ferner ein Verfahren zum Herstellen einer entsprechenden Halbleiter-Bauelementstruktur. Das Verfahren beinhaltet ein Bereitstellen eines Substrats mit einer auf einer ersten Substratseite gelegenen ersten Hauptoberfläche und einer auf einer gegenüberliegenden zweiten Substratseite gelegenen zweiten Hauptoberfläche, sowie ein Strukturieren einer vertikalen Durchkontaktierung, die sich zwischen der ersten Hauptoberfläche und der zweiten Hauptoberfläche vollständig durch das Substrat hindurch erstreckt. Das Verfahren beinhaltet ferner ein Anordnen eines planaren Schichtstapels auf der ersten Hauptoberfläche des Substrats, wobei der Schritt des Anordnens des planaren Schichtstapels beinhaltet, dass eine Metallisierungsschicht auf der ersten Substratseite im Bereich der Durchkontaktierung angeordnet wird, sodass die Metallisierungsschicht galvanisch mit der Durchkontaktierung verbunden ist, und eine Verbindungshalbleiter-Schicht wird auf der Metallisierungsschicht angeordnet wird, sodass die Verbindungshalbleiter-Schicht galvanisch mit der Metallisierungsschicht verbunden ist. Bezüglich der Vorteile des Verfahrens wird auf die obigen Ausführungen zur entsprechenden Vorrichtung verwiesen.

Einige Ausführungsbeispiele sind exemplarisch in der Zeichnung dargestellt und werden nachstehend erläutert. Es zeigen:
- Fig. 1: eine schematische seitliche Schnittansicht einer Halbleiter-Bauelementstruktur gemäß einem Ausführungsbeispiel,
- Fig. 2: eine schematische seitliche Schnittansicht eines mit der erfindungsgemäßen Halbleiter-Bauelementstruktur erzeugbaren 3D-Halbleiterbauelements gemäß einem Ausführungsbeispiel,
- Fig. 3: ein schematisches Blockdiagramm zur Darstellung einzelner Verfahrensschritte eines Verfahrens zum Herstellen einer vertikalen Verbindungshalb-leiter-Struktur gemäß einem Ausführungsbeispiel,
- Fig. 4A: eine schematische seitliche Schnittansicht des Anschlussaufbaus einer Halbleiter-Bauelementstruktur gemäß einem Ausführungsbeispiel, wobei die Verbindungshalbleiter-Schicht mittels eines Abscheideverfahrens auf der Metallisierungsschicht abgeschieden ist,
- Fig. 4B: eine schematische seitliche Schnittansicht des Anschlussaufbaus einer Halbleiter-Bauelementstruktur gemäß einem Ausführungsbeispiel, wobei die Verbindungshalbleiter-Schicht mittels chemischer Umsetzung aus zumindest einem Teil der Metallisierungsschicht erzeugt ist, und
- Figs. 5A-5D: schematische seitliche Schnittansichten zur Veranschaulichung einzelner Verfahrensschritte zum Herstellen einer erfindungsgemäßen Halbleiter-Bauelementstruktur gemäß einem Ausführungsbeispiel, wobei mehrere Verbindungshalbleiter-Schichten mittels chemischer Umsetzung aus mehreren Metallisierungsschichten erzeugt werden.

Im Folgenden werden Ausführungsbeispiele mit Bezug auf die Figuren näher beschrieben, wobei Elemente mit derselben oder ähnlichen Funktion mit denselben Bezugszeichen versehen sind.

Verfahrensschritte, die in einem Blockdiagramm dargestellt und mit Bezugnahme auf das selbige erläutert werden, können auch in einer anderen als der abgebildeten beziehungsweise beschriebenen Reihenfolge ausgeführt werden. Außerdem sind Verfahrensschritte, die ein bestimmtes Merkmal einer Vorrichtung betreffen mit ebendiesem Merkmal der Vorrichtung austauschbar, was ebenso anders herum gilt.

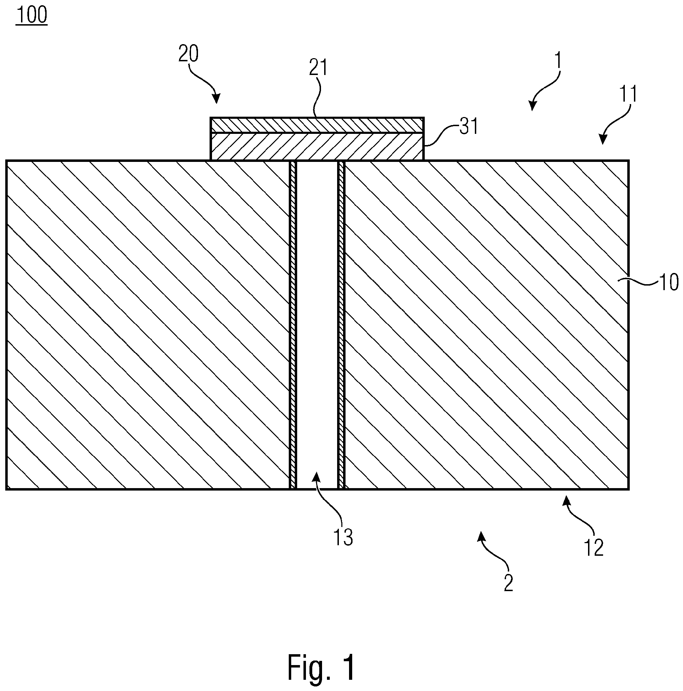

Figur 1 zeigt eine schematische seitliche Schnittansicht einer erfindungsgemäßen Halbleiter-Bauelementstruktur 100. Die Halbleiter-Bauelementstruktur 100 weist ein Substrat 10 mit einer auf einer ersten Substratseite 1 gelegenen ersten Hauptoberfläche 11 und einer auf einer gegenüberliegenden zweiten Substratseite 2 gelegenen zweiten Hauptoberfläche 12 auf.

Die Halbleiter-Bauelementstruktur 100 weist ferner eine vertikale Durchkontaktierung 13 auf. Die vertikale Durchkontaktierung 13 erstreckt sich zwischen der ersten Hauptoberfläche 11 des Substrats 10 und der zweiten Hauptoberfläche 12 des Substrats 10 vollständig durch das Substrat 10 hindurch.

Die vertikale Durchkontaktierung 13 kann zumindest teilweise, oder vorzugsweise vollständig, mit einem elektrisch leitfähigen Material gefüllt sein. Hierbei kann es sich beispielsweise um ein Metall, und insbesondere um ein Übergangsmetall handeln.

Auf der ersten Substratseite 1 ist im Bereich der vertikalen Durchkontaktierung 13 eine elektrisch leitfähige Schicht 31 angeordnet. Im Bereich der vertikalen Durchkontaktierung 13 bedeutet, dass die elektrisch leitfähige Schicht 31 die vertikale Durchkontaktierung 13 in einer Draufsicht zumindest abschnittsweise bedeckt. Dies ist vorteilhaft, da so die Signalleitungswege zwischen der elektrisch leitfähigen Schicht 31 und der vertikalen Durchkontaktierung 13 möglichst kurz gehalten werden können.

Die elektrisch leitfähige Schicht 31 kann dasselbe Material aufweisen wie die vertikale Durchkontaktierung 13. Außerdem ist es denkbar, dass die elektrisch leitfähige Schicht 31 ein Teil der vertikalen Durchkontaktierung 13 ist. Beispielsweise kann die vertikale Durchkontaktierung 13 mit elektrisch leitfähigem Material gefüllt werden, zum Beispiel mittels Abscheidung. Dabei kann das elektrisch leitfähige Material zumindest teilweise auch auf der ersten Substratseite 1 im Bereich der vertikalen Durchkontaktierung 13 abgeschieden werden, sodass das auf der ersten Substratseite 1 abgeschiedene Material die elektrisch leitfähige Schicht 31 bildet. Das heißt, die elektrisch leitfähige Schicht 31 wäre aus dem Material der vertikalen Durchkontaktierung 13 gebildet und somit ein Bestandteil der vertikalen Durchkontaktierung 13. In anderen Worten könnten demnach also die vertikale Durchkontaktierung 13 und die elektrisch leitfähige Schicht 31 einstückig ausgestaltet sein.

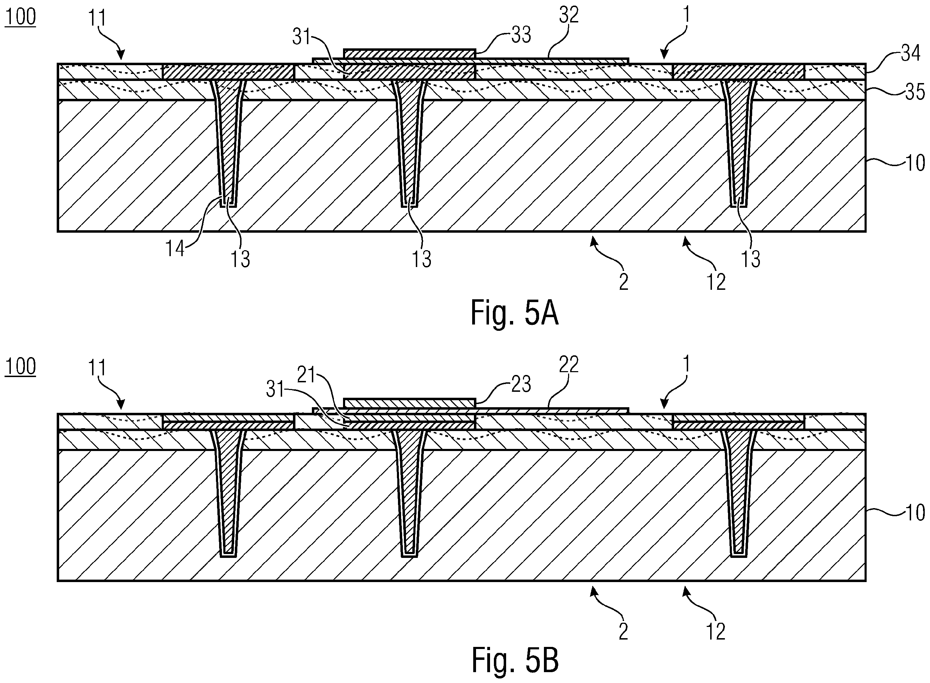

In dem hier abgebildeten Ausführungsbeispiel kann die elektrisch leitfähige Schicht 31 direkt und unmittelbar auf der ersten Hauptoberfläche 11 des Substrats 10 angeordnet sein. In anderen Ausführungsbeispielen (z.B. Figuren 5A-5D) kann eine zusätzliche elektrisch isolierende Schicht 35 zwischen der ersten Hauptoberfläche 11 des Substrats 10 und der elektrisch leitfähigen Schicht 31 angeordnet sein. Selbiges gilt natürlich ebenso für die gegenüberliegende zweite Substratseite 2 beziehungsweise für die zweite Hauptoberfläche 12 des Substrats 10.

Bei der elektrisch leitfähigen Schicht 31 kann es sich beispielsweise um eine Metallisierungsschicht handeln. Eine Metallisierungsschicht wird hierin als ein nicht-limitierendes Beispiel einer elektrisch leitfähigen Schicht beschrieben. Die auf der ersten Substratseite 1 angeordnete Metallisierungsschicht 31 ist galvanisch mit der vertikalen Durchkontaktierung 13 verbunden. Die Metallisierungsschicht 31 kann beispielsweise ein Übergangsmetall aufweisen.

Auf der Metallisierungsschicht 31 ist eine Verbindungshalbleiter-Schicht 21 angeordnet. Die Verbindungshalbleiter-Schicht 21 kann direkt und unmittelbar auf der Metallisierungsschicht 31 angeordnet sein. Es wäre aber auch denkbar, dass eine oder mehrere zusätzliche Schichten, und insbesondere elektrisch leitfähige Schichten, zwischen der Verbindungshalbleiter-Schicht 21 und der Metallisierungsschicht 31 angeordnet sind. In diesem Fall wäre die Verbindungshalbleiter-Schicht 21 indirekt über die jeweiligen zusätzlichen Schichten auf der Metallisierungsschicht 31 angeordnet. Die Verbindungshalbleiter-Schicht 21 ist galvanisch mit der Metallisierungsschicht 31 verbunden.

Es kann demnach also ein Schichtstapel 20 auf der ersten Substratseite 1 beziehungsweise auf der ersten Hauptoberfläche 11 des Substrats 10 erzeugt werden. Der Schichtstapel 20 weist in dem abgebildeten Ausführungsbeispiel die Metallisierungsschicht 31 und die Verbindungshalbleiter-Schicht 21 auf. Es ist aber auch denkbar, dass der Schichtstapel 20 weitere zusätzliche Schichten aufweist, wie dies später unter Bezugnahme auf die nachfolgenden Figuren erläutert werden wird.

Der Schichtstapel 20 kann in Planartechnik erzeugt werden. Dabei können die Schichten des Schichtstapels 20 (hier: die Metallisierungsschicht 31 und die Verbindungshalbleiter-Schicht 21) planar bzw. waagerecht bzw. horizontal auf der ersten Substratseite 1 beziehungsweise auf der ersten Hauptoberfläche 11 des Substrats 10, und im Wesentlichen parallel zu der ersten Substratseite 1 beziehungsweise zu der ersten Hauptoberfläche 11 des Substrats 10, angeordnet werden.

Die Verbindungshalbleiter-Schicht 21 und die Metallisierungsschicht 31 können dieselbe Schichtdicke aufweisen. Es sind jedoch auch unterschiedliche Schichtdicken denkbar. Beispielsweise kann die Verbindungshalbleiter-Schicht 21 eine geringere Schichtdicke aufweisen als die Metallisierungsschicht 31. Dies kann unter anderem darin begründet sein, dass die Metallisierungsschicht 31 dazu dienen kann, um die Verbindungshalbleiter-Schicht 21 möglichst großflächig, und vorzugsweise vollflächig, zu kontaktieren. Die Verbindungshalbleiter-Schicht 21 hingegen kann vorzugsweise als monokristallines 2D-Material ausgestaltet sein, welches lediglich eine oder mehrere wenige (z.B. zwei bis fünf) einzelne Atomlagen aufweist und somit extrem dünn ist.

Erfindungsgemäß weist die Verbindungshalbleiter-Schicht 21 einen auf der Metallisierungsschicht 31 angeordneten und mit der Metallisierungsschicht 31 galvanisch verbundenen Verbindungshalbleiter auf. Der Verbindungshalbleiter ist definitionsgemäß zu unterscheiden von einem Elementhalbleiter. Während der Elementhalbleiter aus einem einzigen Element, z.B. Silizium aufgebaut ist, sind Verbindungshalbleiter aus mehreren Elementen aufgebaut

Darüber hinaus ist es vorteilhaft, wenn der Verbindungshalbleiter monokristallin vorliegt. Allerdings kann beispielsweise der Elementhalbleiter Silizium nicht monokristallin auf der elektrisch leitfähigen Schicht abgeschieden werden, da hierfür die Abscheidetemperatur bei der Prozessierung über die Schmelztemperatur von Silizium erhöht werden müsste, was in der Praxis zwangsläufig zu Schäden an den umliegenden Bauteilen und Komponenten führen würde.

Daher kann die Verbindungshalbleiter-Schicht 21 gemäß einer Ausführungsform ein sogenanntes 2D-Material aufweisen. Für eine genauere Definition des 2D-Materials wird auf die Absätze im obigen allgemeinen Beschreibungsteil verwiesen. Das 2D-Material hat die Eigenschaft und somit den Vorteil, dass es einkristallin auf der Metallisierungsschicht 31 angeordnet werden kann. Dabei bildet das 2D-Material Schichten aus, die auf Molekularebene aus einzelnen Atomlagen, den sogenannten Monolayern, bestehen. Das 2D-Material kann eine einzelne Atomlage aufweisen, oder mehrere Atomlagen können sich zu einem gemeinsamen 2D-Verbundmaterial zusammenschließen.

Vorteilhafter Weise kann die Verbindungshalbleiter-Schicht 21 mindestens ein Material aus der Gruppe der Übergangsmetall-Chalkogenide aufweisen. Das heißt, die Verbindungshalbleiter-Schicht 21 kann eine Elementkombination aus der Gruppe der Übergangsmetalle und der Gruppe der Chalkogeniden aufweisen. Beispielsweise kann die Verbindungshalbleiter-Schicht 21 ein 2D-Verbundmaterial mit mindestens einem Material aus der Gruppe der Übergangsmetall-Chalkogenide, beziehungsweise mit einer Elementkombination aus der Gruppe der Übergangsmetalle und der Gruppe der Chalkogeniden aufweisen. Übergangsmetall-Chalkogenide beziehungsweise Elementkombinationen aus der Gruppe der Übergangsmetalle und der Gruppe der Chalkogeniden sind atomar dünne Halbleiter vom Typ MX₂, wobei M ein Übergangsmetall-Atom (z.B. Mo, W, etc.) bezeichnet und X ein Chalkogenid-Atom (z.B. S, Se oder Te) bezeichnet. Dabei ist in der Regel eine Lage von M-Atomen zwischen zwei Lagen von X-Atomen angeordnet. Hierzu zählen zum Beispiel MoS₂, WS₂, MoSe₂, WSe₂, MoTe₂.

Die erfindungsgemäße Halbleiter-Bauelementstruktur 100 kann vorteilhaft zum Aufbau von 3D-Systemen (z.B. 3D-ICs, 3D-Packages) genutzt werden. Bei 3D-Systemen werden mehrere, meist in Planartechnik gefertigte Bauelementstrukturen vertikal übereinander angeordnet. Die erfindungsgemäße Halbleiter-Bauelementstruktur 100 kann eine dieser Bauelementstrukturen darstellen, wobei eine zusätzliche separate Bauelementstruktur vertikal oberhalb der Halbleiter-Bauelementstruktur 100, d.h. der ersten Substratseite 1 beziehungsweise der ersten Hauptoberfläche 11 des Substrats 10 gegenüberliegend, und/oder eine weitere zusätzliche separate Bauelementstruktur vertikal unterhalb der Halbleiter-Bauelementstruktur 100, d.h. der zweiten Substratseite 2 beziehungsweise der zweiten Hauptoberfläche 12 des Substrats 10 gegenüberliegend, angeordnet wäre. Somit kann ein 3D-System mit mehreren vertikal übereinander angeordneten Bauelementstrukturen gebildet werden, wobei die einzelnen Bauelementstrukturen mittels der vertikalen Durchkontaktierung 13 untereinander galvanisch und gegebenenfalls mechanisch verbunden werden können.

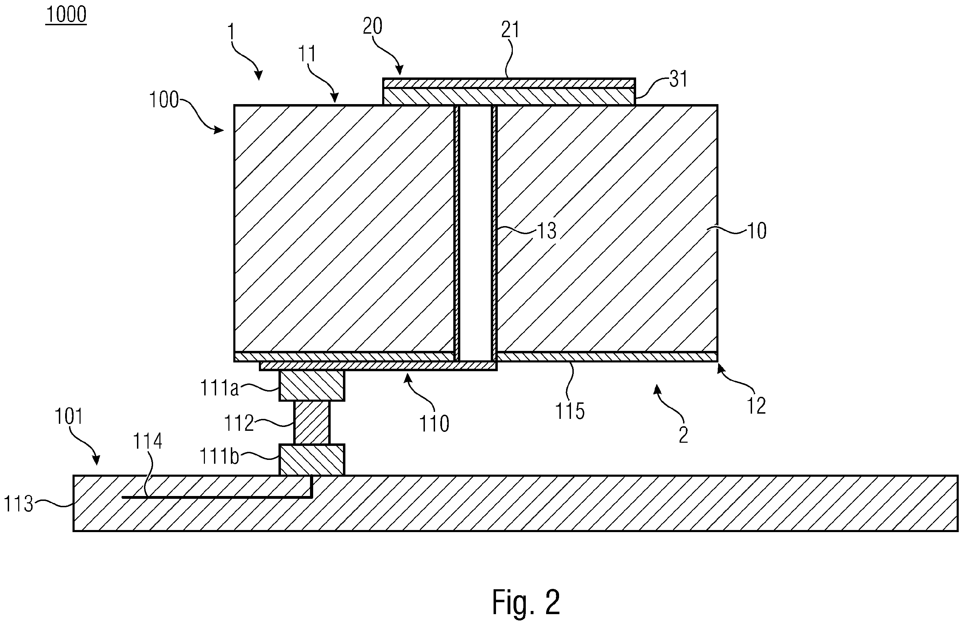

Figur 2 zeigt ein Ausführungsbeispiel eines erfindungsgemäßen dreidimensionalen Halbleiter-Bauelements 1000 mit einer erfindungsgemäßen Halbleiter-Bauelementstruktur 100 und einer zusätzlichen separaten elektronischen Bauelementstruktur 101. In diesem Ausführungsbeispiel ist die zusätzliche separate elektronische Bauelementstruktur 101 vertikal unterhalb der erfindungsgemäßen Halbleiter-Bauelementstruktur 100 angeordnet. Das heißt, die zusätzliche separate elektronische Bauelementstruktur 101 ist der zweiten Substratseite 2 beziehungsweise der zweiten Hauptoberfläche 12 des Substrats 10 gegenüberliegend angeordnet.

In diesem Ausführungsbeispiel ist außerdem auf der zweiten Substratseite 2 ein Kontaktierungsabschnitt 110 angeordnet. Der Kontaktierungsabschnitt 110 kann elektrisch leitfähiges Material aufweisen. Der Kontaktierungsabschnitt 110 kann, wie abgebildet, eine Schicht aufweisen, die galvanisch mit der vertikalen Durchkontaktierung 13 verbunden ist. Wie in Figur 2 dargestellt ist, kann auf der zweiten Hauptoberfläche 12 des Substrats 10 optional eine elektrisch isolierende Schicht 115 angeordnet sein, und der Kontaktierungsabschnitt 110 beziehungsweise die Kontaktierungsschicht 110 kann auf dieser elektrisch isolierenden Schicht 115 angeordnet sein. Dies ist vorteilhaft, wenn das Substrat 10 elektrisch leitende Eigenschaften aufweist. Alternativ kann der Kontaktierungsabschnitt 110 direkt auf der zweiten Hauptoberfläche 12 des Substrats 10 angeordnet sein, zum Beispiel falls das Substrat 10 selbst keine elektrisch leitenden Eigenschaften aufweist. Alternativ oder zusätzlich kann der Kontaktierungsabschnitt 110 eine Verdrahtung aufweisen.

Die Halbleiter-Bauelementstruktur 100 ist mittels diesem Kontaktierungsabschnitt 110 galvanisch und/oder mechanisch mit der zusätzlichen separaten elektronischen Bauelementstruktur 101 verbunden. Diese Verbindung kann beispielsweise mittels eines sogenannten Intermetallic Compound (IMC) Verbindungsverfahrens realisiert werden. Beispielsweise kann der Kontaktierungsabschnitt 110 einen oder mehrere Metallpads 111a aufweisen. Auch die zusätzliche separate elektronische Bauelementstruktur 101 kann ihrerseits einen oder mehrere Metallpads 111b aufweisen. Zwischen den Metallpads 111a, 111b können Kontaktpads 112 angeordnet sein, um die Metallpads 111a, 111b galvanisch und/oder mechanisch miteinander zu verbinden. Die Metallpads 111a, 111b können beispielsweise Kupfer aufweisen, und die Kontaktpads 112 können beispielsweise Kupfer und/oder Zinn aufweisen.

Alternativ oder zusätzlich wäre es denkbar, dass die zusätzliche separate Bauelementstruktur 101 bzw. eine weitere (nicht abgebildete) zusätzliche separate Bauelementstruktur der ersten Hauptseite 1 beziehungsweise der ersten Hauptoberfläche 11 des Substrats 10 gegenüberliegend angeordnet wäre. In diesem Fall könnte ein Kontaktierungsabschnitt auf der ersten Hauptoberfläche 11 des Substrats 10 beziehungsweise auf einer auf der ersten Hauptoberfläche 11 angeordneten optionalen elektrisch isolierenden Schicht 115 angeordnet und galvanisch mit der vertikalen Durchkontaktierung 13 verbunden sein. Dieser Kontaktierungsabschnitt könnte dann dazu dienen, um die (nicht dargestellte) der ersten Hauptoberfläche 11 des Substrats 10 gegenüberliegend angeordnete Bauelementstruktur galvanisch zu kontaktieren.

Wie in Figur 2 zu sehen ist, kann die zusätzliche separate elektronische Bauelementstruktur 101 beispielsweise ein Substrat 113 mit integrierten Metallisierungs-Layern 114 aufweisen. Die Metallisierungs-Layer 114 können mittels dem Kontaktierungsabschnitt 110 mit der erfindungsgemäßen Halbleiter-Bauelementstruktur 100, und insbesondere mit der Verbindungshalbleiter-Schicht 21, galvanisch verbunden sein.

Der Kontaktierungsabschnitt 110 kann also galvanisch mit der vertikalen Durchkontaktierung 13 verbunden sein. Über diese Anordnung kann das abgebildete dreidimensionale elektronische Halbleiter-Bauelement 1000 erzeugt werden, wobei die Verbindungshalbleiter-Schicht 21 über die vertikale Durchkontaktierung 13 galvanisch mit der separaten elektronischen Bauelementstruktur 101 verbunden sein kann.

Die in Figur 2 beispielhaft gegenüber von der zweiten Substratseite 2 beziehungsweise von der zweiten Hauptoberfläche 12 des Substrats 10 angeordnete zusätzliche separate elektronische Bauelementstruktur 101 kann ihrerseits eine hierin beschriebene erfindungsgemäße Halbleiter-Bauelementstruktur 100 sein. Alternativ kann die zusätzliche separate elektronische Bauelementstruktur 101, wie in Figur 2 abgebildet, ein in Planartechnik hergestelltes 2D-System sein. Die zusätzliche separate elektronische Bauelementstruktur 101 kann beispielsweise einen IC aufweisen, der wiederum mit Schaltungsstrukturen der erfindungsgemäßen Halbleiter-Bauelementstruktur 100 zusammenwirkt, um ein 3D-IC zu bilden. Alternativ kann die zusätzliche separate elektronische Bauelementstruktur 101 ein eigenständiges Bauelement, zum Beispiel einen Chip, aufweisen, der zusammen mit der erfindungsgemäßen Halbleiter-Bauelementstruktur 100 ein 3D-Package bildet.

In dem in Figur 2 abgebildeten Ausführungsbeispiel ist der Kontaktierungsabschnitt 110 auf der zweiten Substratseite 2 zwischen dem Substrat 10 und der zusätzlichen separaten elektronischen Bauelementstruktur 101 angeordnet. Alternativ oder zusätzlich kann eine weitere zusätzliche separate elektronische Bauelementstruktur (nicht abgebildet) oberhalb der Halbleiter-Bauelementstruktur 100, d.h. der ersten Substratseite 1 beziehungsweise der ersten Hauptoberfläche 11 des Substrats 10 gegenüberliegend, angeordnet sein.

Sofern eine zusätzliche separate elektronische Bauelementstruktur 101 und darüber hinaus noch eine (nicht abgebildete) zusätzliche separate elektronische Bauelementstruktur in der oben beschriebenen Art und Weise mit der erfindungsgemäßen Halbleiter-Bauelementstruktur 100 verbunden wären, wäre die erfindungsgemäße Halbleiter-Bauelementstruktur 100 zwischen diesen zwei zusätzlichen separaten elektronischen Bauelementstrukturen angeordnet, sodass im Ergebnis ebenfalls ein dreidimensionales elektronisches Halbleiter-Bauelement 1000 (z.B. 3D-IC oder 3D-Package) gebildet wird.

Im Übrigen gelten alle unter Bezugnahme auf Figur 2 diskutierten Merkmale der unterhalb, d.h. gegenüber der zweiten Substratseite 2 beziehungsweise der zweiten Hauptoberfläche 12, angeordneten zusätzlichen separaten elektronischen Bauelementstruktur 101 ebenfalls für eine (nicht abgebildete) oberhalb, d.h. gegenüber der ersten Substratseite 1 beziehungsweise der ersten Hauptoberfläche 11, angeordnete zusätzliche separate elektronische Bauelementstruktur.

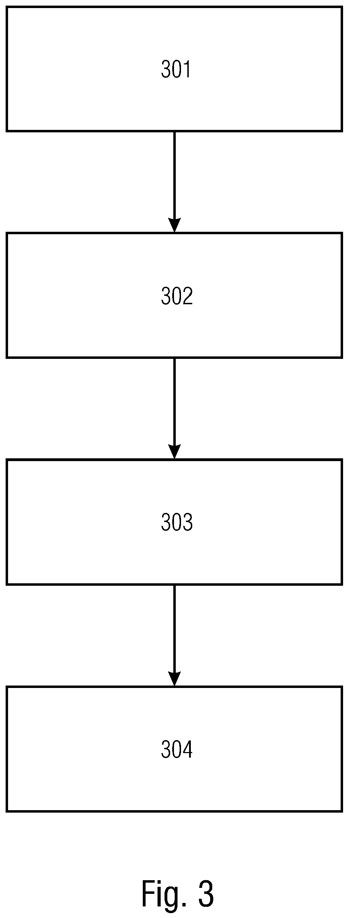

Figur 3 zeigt ein Blockdiagramm eines erfindungsgemäßen Verfahrens zum Herstellen einer Halbleiter-Bauelementstruktur 100.

In Block 301 wird ein Substrat 10 mit einer auf einer ersten Substratseite 1 gelegenen ersten Hauptoberfläche 11 und einer auf einer gegenüberliegenden zweiten Substratseite 2 gelegenen zweiten Hauptoberfläche 12 bereitgestellt.

In Block 302 wird eine vertikale Durchkontaktierung 13 strukturiert, wobei sich die vertikale Durchkontaktierung 13 zwischen der ersten Hauptoberfläche 11 und der zweiten Hauptoberfläche 12 vollständig durch das Substrat 10 hindurch erstreckt.

In Block 303 wird eine Metallisierungsschicht 31 auf der ersten Substratseite 1 im Bereich der Durchkontaktierung 13 angeordnet, sodass die Metallisierungsschicht 31 galvanisch mit der Durchkontaktierung 13 verbunden ist.

In Block 304 wird eine Verbindungshalbleiter-Schicht 21 auf der Metallisierungsschicht 31 angeordnet, sodass die Verbindungshalbleiter-Schicht 21 galvanisch mit der Metallisierungsschicht 31 verbunden ist.

Wenn die Schritte 303 und 304 in der angegebenen Reihenfolge ausgeführt werden, führt dies zu einem Schichtstapel 20, bei dem die Metallisierungsschicht 31 zwischen der Verbindungshalbleiter-Schicht 21 und dem Substrat 10 angeordnet ist.

Die Schritte 303 und 304 können jedoch auch umgekehrt ausgeführt werden. In diesem Fall würde sich ein Schichtstapel 20 ergeben, bei dem die Verbindungshalbleiter-Schicht 21 zwischen der Metallisierungsschicht 31 und dem Substrat 10 angeordnet ist.

Generell gilt, dass alle hierin beschriebenen Verfahrensschritte auch in einer anderen als der angegebenen Reihenfolge ausgeführt werden können.

Die Verbindungshalbleiter-Schicht 21 kann erfindungsgemäß auf zwei unterschiedliche Arten auf der Metallisierungsschicht 31 angeordnet werden. In einer ersten Ausführungsform kann die Verbindungshalbleiter-Schicht 21 auf der Metallisierungsschicht 31 abgeschieden werden. Die Temperaturen zum Abscheiden von, zum Beispiel einkristallinen 2D-Materialien, können wesentlich geringer sein als die Temperaturen zum Abscheiden von einkristallinem Silizium. Eine Prozesskompatibilität kann dadurch gewährleistet werden.

In einem zweiten Ausführungsbeispiel kann die Verbindungshalbleiter-Schicht 21 mittels chemischer Umsetzung gebildet werden. Hierfür kann ein Teil der Metallisierungsschicht 31 mittels geeigneter Reaktionspartner in eine Verbindungshalbleiter-Schicht 21 umgewandelt bzw. umgesetzt werden. Beispielsweise kann die Metallisierungsschicht 31 ein Material aus der Gruppe der Übergangsmetalle aufweisen, wie z.B. Molybdän. Ein geeigneter Reaktionspartner zur Umsetzung wäre beispielsweise Schwefel. Der Schwefel verbindet sich mit dem Molybdän zu Molybdän(IV)-Disulfid MoS₂, welches nach der Umsetzung direkt als einkristallines 2D-Verbundmaterial bzw. als Monolayer vorliegt.

Alternativ kann, anstatt einen Teil der Metallisierungsschicht 31 umzusetzen, auf der Metallisierungsschicht 31 ein geeignetes Material, zum Beispiel ein Metall und insbesondere ein Übergangsmetall, angeordnet werden. Beispielsweise kann auch hier wieder ein Material aus der Gruppe der Übergangsmetalle auf der Metallisierungsschicht 31 angeordnet werden. Mit einem geeigneten Reaktionspartner, z.B. Schwefel, kann dann diese zusätzliche Materialschicht in die Verbindungshalbleiter-Schicht 21 umgewandelt bzw. umgesetzt werden.

Der Vorteil der chemischen Umsetzung im Vergleich zur Abscheidung liegt darin, dass die jeweiligen Schichtdicken der Metallisierungsschicht 31 und der Verbindungshalbleiter-Schicht 21 bei der chemischen Umsetzung deutlich geringer ausfallen können als bei der Abscheidung. Beim Abscheiden wird nämlich die Verbindungshalbleiter-Schicht 21 als zusätzliches Material auf der Metallisierungsschicht 31 aufgebracht, d.h. die Gesamtschichtdicke des Schichtstapels 20 setzt sich zusammen aus der Schichtdicke der Metallisierungsschicht 31 plus der Schichtdicke der darauf angeordneten Verbindungshalbleiter-Schicht 21. Bei der chemischen Umsetzung hingegen wird die Metallisierungsschicht 31 zumindest teilweise in die Verbindungshalbleiter-Schicht 21 umgewandelt bzw. umgesetzt. Hierbei setzt sich die Gesamtschichtdicke des Schichtstapels 20 demnach lediglich aus der Schichtdicke der ursprünglichen Metallisierungsschicht 31 zusammen.

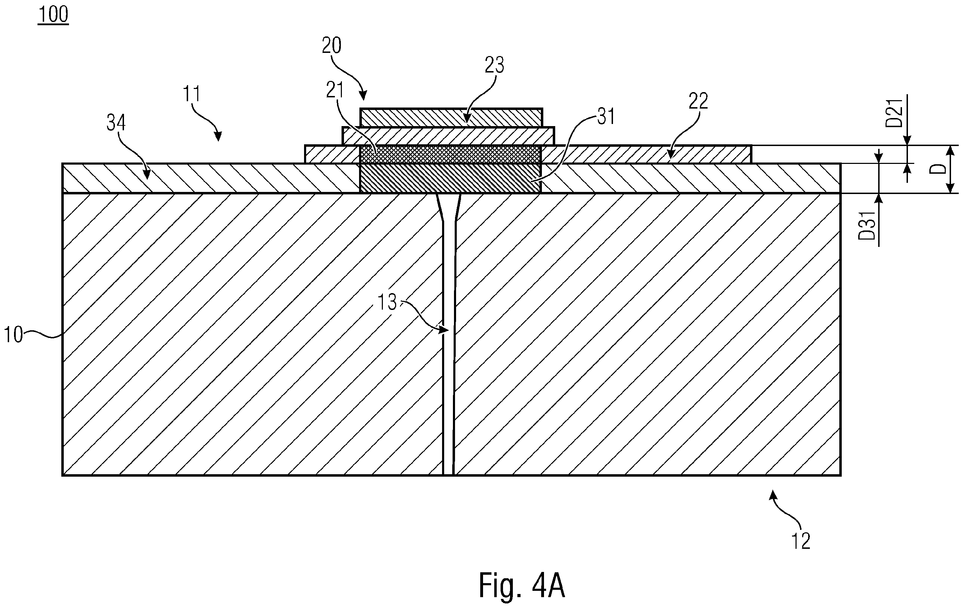

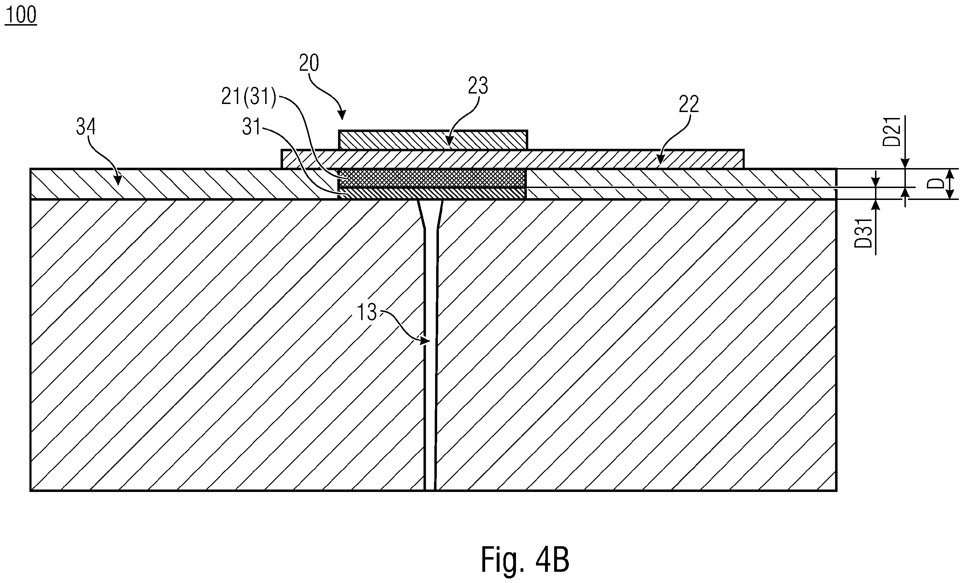

Dies soll nachfolgend unter Bezugnahme auf die Figuren 4A und 4B verdeutlicht werden. Figur 4A zeigt ein Ausführungsbeispiel einer erfindungsgemäßen Halbleiter-Bauelementstruktur 100, wobei die Verbindungshalbleiter-Schicht 21 mittels eines Abscheideprozesses auf der Metallisierungsschicht 31 abgeschieden wurde. Figur 4B zeigt ein Ausführungsbeispiel einer erfindungsgemäßen Halbleiter-Bauelementstruktur 100, wobei die Verbindungshalbleiter-Schicht 21 mittels chemischer Umsetzung aus zumindest einem Teil der Metallisierungsschicht 31 gebildet wurde.

In den Figuren 4A und 4B weist der horizontale bzw. planare Schichtstapel 20 neben der Metallisierungsschicht 31 und der darauf abgeschiedenen Verbindungshalbleiter-Schicht 21 zusätzlich noch weitere Schichten auf. Beispielsweise kann der Schichtstapel 20 eine zweite Verbindungshalbleiter-Schicht 22 aufweisen. Die zweite Verbindungshalbleiter-Schicht 22 kann auf der zuvor beschriebenen Verbindungshalbleiter-Schicht 21, die in einem Schichtstapel 20 mit mehreren Schichten auch als eine erste Verbindungshalbleiter-Schicht 21 bezeichnet werden kann, angeordnet und galvanisch mit dieser verbunden sein.

Dabei kann die zweite Verbindungshalbleiter-Schicht 22 auf der der Metallisierungsschicht 31 gegenüberliegenden Seite der ersten Verbindungshalbleiter-Schicht 21 angeordnet sein, sodass die erste Verbindungshalbleiter-Schicht 21 zwischen der Metallisierungsschicht 31 und der zweiten Verbindungshalbleiter-Schicht 22 angeordnet ist. Die zweite Verbindungshalbleiter-Schicht 22 kann direkt bzw. unmittelbar auf der ersten Verbindungshalbleiter-Schicht 21 angeordnet sein.

Die zweite Verbindungshalbleiter-Schicht 22 kann ebenfalls eines der zuvor mit Bezug auf die erste Verbindungshalbleiter-Schicht 21 beschriebenen Materialien aufweisen, z.B. ein 2D-Verbundmaterial, und insbesondere ein Material aus der Gruppe der Übergangsmetall-Chalkogenide, wie z.B. MoS₂. Die zweite Verbindungshalbleiter-Schicht 22 kann ebenfalls, wie zuvor mit Bezug auf die erste Verbindungshalbleiter-Schicht 21 beschrieben, mittels Abscheidung oder mittels chemischer Umsetzung auf der ersten Verbindungshalbleiter-Schicht 21 angeordnet werden. Zur chemischen Umsetzung kann beispielsweise ein geeignetes zusätzliches Material, zum Beispiel ein Metall oder Übergangsmetall, auf der ersten Verbindungshalbleiter-Schicht 21 vorabgeschieden werden, welches dann mittels der chemischen Umsetzung in die zweite Verbindungshalbleiter-Schicht 22 umgewandelt bzw. umgesetzt werden kann.

In den Figuren 4A und 4B sind noch weitere Schichten gezeigt. Sofern aber der Schichtstapel 20 zumindest die erste Verbindungshalbleiter-Schicht 21 und die zweite Verbindungshalbleiter-Schicht 22 aufweist, kann die erfindungsgemäße Halbleiter-Bauelementstruktur 100 als eine Diodenstruktur realisiert werden.

Der horizontale bzw. planare Schichtstapel 20 kann ferner eine dritte Verbindungshalbleiter-Schicht 23 aufweisen. Die dritte Verbindungshalbleiter-Schicht 23 kann auf der zuvor beschriebenen zweiten Verbindungshalbleiter-Schicht 22 angeordnet und galvanisch mit dieser verbunden sein.

Dabei kann die dritte Verbindungshalbleiter-Schicht 23 auf der der ersten Verbindungshalbleiter-Schicht 21 gegenüberliegenden Seite der zweiten Verbindungshalbleiter-Schicht 22 angeordnet sein, sodass die zweite Verbindungshalbleiter-Schicht 22 zwischen der ersten Verbindungshalbleiter-Schicht 21 und der dritten Verbindungshalbleiter-Schicht 23 angeordnet ist. Die dritte Verbindungshalbleiter-Schicht 23 kann direkt bzw. unmittelbar auf der zweiten Verbindungshalbleiter-Schicht 22 angeordnet sein.

Die dritte Verbindungshalbleiter-Schicht 23 kann ebenfalls eines der zuvor mit Bezug auf die erste Verbindungshalbleiter-Schicht 21 beschriebenen Materialien aufweisen, z.B. ein 2D-Verbundmaterial, und insbesondere ein Material aus der Gruppe der Übergangsmetall-Chalkogenide, wie z.B. MoS₂. Die dritte Verbindungshalbleiter-Schicht 23 kann ebenfalls, wie zuvor mit Bezug auf die erste Verbindungshalbleiter-Schicht 21 beschrieben, mittels Abscheidung oder mittels chemischer Umsetzung auf der zweiten Verbindungshalbleiter-Schicht 22 angeordnet werden. Zur chemischen Umsetzung kann beispielsweise ein geeignetes zusätzliches Material, zum Beispiel ein Metall oder Übergangsmetall, auf der zweiten Verbindungshalbleiter-Schicht 22 vorabgeschieden werden, welches dann mittels der chemischen Umsetzung in die dritte Verbindungshalbleiter-Schicht 23 umgewandelt bzw. umgesetzt werden kann.

Sofern der Schichtstapel 20 die in den Figuren 4A und 4B gezeigten Verbindungshalbleiter-Schichten, d.h. die erste Verbindungshalbleiter-Schicht 21, die zweite Verbindungshalbleiter-Schicht 22 sowie die dritte Verbindungshalbleiter-Schicht 23 aufweist, kann die erfindungsgemäße Halbleiter-Bauelementstruktur 100 als eine Transistorstruktur realisiert werden.

Es ist außerdem denkbar, dass zwischen den einzelnen Schichten 21, 22, 23, 31 weitere Schichten angeordnet sind, zum Beispiel Metallisierungsschichten.

Wie eingangs erwähnt, kann das Anordnen der Verbindungshalbleiter-Schicht 21 auf der Metallisierungsschicht 31 mittels chemischer Umsetzung den Vorteil aufweisen, dass die Gesamtschichtdicke dünner ausfällt als beim Abscheiden der Verbindungshalbleiter-Schicht 21.

So ist beispielsweise in Figur 4A zu sehen, dass die Verbindungshalbleiter-Schicht 21 direkt auf der Metallisierungsschicht 31 abgeschieden ist. Dabei weist die Metallisierungsschicht 31 eine Schichtdicke D31 auf, und die Verbindungshalbleiter-Schicht 21 weist eine Schichtdicke D21 auf. Beide Schichten zusammen weisen eine Gesamtschichtdicke D auf, die sich aus den beiden Schichtdicken D21 und D31 zusammensetzt.

In Figur 4B ist zu sehen, dass die Verbindungshalbleiter-Schicht 21 mittels chemischer Umsetzung aus zumindest einem Teil der Metallisierungsschicht 31 gebildet ist. Die ursprüngliche Schichtdicke der Metallisierungsschicht 31 entspricht der gezeigten Schichtdicke D. Ein oberer Teil, d.h. ein der ersten Substratseite 1 beziehungsweise der ersten Hauptoberfläche 11 des Substrats 10 abgewandter Abschnitt der Metallisierungsschicht 31 wurde chemisch umgesetzt, wodurch die Verbindungshalbleiter-Schicht 21 erzeugt wurde. Das heißt, ein Teil der Metallisierungsschicht 31 wurde umgewandelt zu der Verbindungshalbleiter-Schicht 21.

Die ursprüngliche Schichtdicke D der Metallisierungsschicht 31 reduziert sich demnach um die Schichtdicke D21 der Verbindungshalbleiter-Schicht 21. Die nach der chemischen Umsetzung verbleibende Schichtdicke der Metallisierungsschicht 31 ist gekennzeichnet mit D31. Die Gesamtschichtdicke D des mittels chemischer Umsetzung erzeugten Schichtstapels 20 mit der Metallisierungsschicht 31 und der Verbindungshalbleiter-Schicht 21 entspricht demnach der ursprünglichen Schichtdicke D der Metallisierungsschicht 31 und ist geringer als die Gesamtschichtdicke D der in Figur 4A gezeigten Schichten 21, 31, bei der die Verbindungshalbleiter-Schicht 21 auf der Metallisierungsschicht 31 abgeschieden wurde.

Ebenfalls ist im direkten Vergleich zwischen den Figuren 4A und 4B zu erkennen, dass der gesamte mittels chemischer Umsetzung erzeugte Schichtstapel 20 deutlich niedriger ist als der mittels Abscheidung erzeugte Schichtstapel 20.

Optional kann zusätzlich eine Isolatorschicht 34 (z.B. Dielektrikum) auf der ersten Substratseite 1 angeordnet werden. Die Isolatorschicht 34 kann beispielsweise direkt auf der ersten Hauptoberfläche 11 des Substrats 10 angeordnet werden. Die Isolatorschicht 34 kann die Metallisierungsschicht 31 lateral gegenüber weiteren elektrisch leitfähigen Strukturen auf dem Substrat 10 elektrisch isolieren.

Die erfindungsgemäße Halbleiter-Bauelementstruktur 100 kann auch mehr als die abgebildeten drei Verbindungshalbleiter-Schichten 21, 22, 23 aufweisen. Beispielsweise kann eine vierte Verbindungshalbleiter-Schicht auf der dritten Verbindungshalbleiter-Schicht 23 angeordnet sein. In diesem Fall könnte beispielsweise eine Thyristorstruktur erzeugt werden. Es kann auch eine fünfte Verbindungshalbleiter-Schicht auf der vierten Verbindungshalbleiter-Schicht angeordnet sein. In diesem Fall könnte beispielsweise eine Memristorstruktur erzeugt werden.

Außerdem können die in Figur 4A abgebildete Verbindungshalbleiter-Schicht 21 und die in Figur 4B abgebildete Verbindungshalbleiter-Schicht 21 unterschiedliche Materialien beziehungsweise unterschiedliche Halbleiter aufweisen. Außerdem kann die in Figur 4A abgebildete Verbindungshalbleiter-Schicht 21 beispielsweise mittels einer chemischen Umsetzung aus einer zuvor auf der Metallisierungsschicht 31 vor-abgeschiedenen Übergangsmetallschicht gebildet werden. Das heißt, auf der Metallisierungsschicht 31 kann eine Schicht, zum Beispiel eine Metallschicht und insbesondere eine Übergangsmetallschicht angeordnet, z.B. abgeschieden werden. Diese vor-abgeschiedene Schicht kann dann mittels chemischer Umsetzung unter Verwendung geeigneter Reaktionspartner ganz oder teilweise zu der Verbindungshalbleiter-Schicht 21 umgewandelt bzw. umgesetzt werden. Im Ergebnis ist die umgewandelte bzw. erzeugte Verbindungshalbleiter-Schicht 21 jedenfalls auf der Metallisierungsschicht 31 angeordnet.

Die Figuren 5A bis 5D zeigen die Herstellung einer erfindungsgemäßen Halbleiter-Bauelementstruktur 100 zu unterschiedlichen Verfahrenszeitpunkten, wobei die Verbindungshalbleiter-Schicht 21 in diesem Beispiel mittels chemischer Umsetzung aus einem Teil der Metallisierungsschicht 31 erzeugt wird. Ein zuvor beschriebenes Abscheiden der Verbindungshalbleiter-Schicht 21 auf der Metallisierungsschicht 31 wäre aber ebenso denkbar.

Das Substrat 10 kann gemäß diesem Beispiel mehrere vertikale Durchkontaktierungen 13 aufweisen. Sofern das Substrat 10 elektrisch leitende Eigenschaften aufweist, können die Durchkontaktierungen 13 optional mittels einer elektrisch isolierenden Schicht 14 elektrisch gegenüber dem Substrat 10 isoliert werden. Das heißt, die vertikalen Durchkontaktierungen 13 können als elektrisch gegenüber dem Substrat 10 isolierte vertikale Durchkontaktierungen ausgestaltet sein. Ferner kann auf der ersten Substratseite 1, zum Beispiel direkt auf der ersten Hauptoberfläche 11 des Substrats 10, optional eine elektrisch isolierende Deckschicht 35 angeordnet werden, wobei sich die Durchkontaktierungen 13 durch diese elektrisch isolierende Deckschicht 35 hindurch erstrecken können. Bei der elektrisch isolierenden Deckschicht 35 kann es sich beispielsweise um ein planarisiertes Dielektrikum handeln.

Auf der ersten Substratseite 1 kann im Bereich der Durchkontaktierungen 13 eine Metallisierungsschicht 31 angeordnet und mit der jeweiligen Durchkontaktierung 13 galvanisch verbunden werden. Beispielsweise kann die Metallisierungsschicht 31, wie in den Figuren zuvor beschrieben, direkt auf der ersten Hauptoberfläche 11 des Substrats 10 angeordnet werden, oder die Metallisierungsschicht 31 kann, wie in den Figuren 5A-5D gezeigt ist, auf der elektrisch isolierenden Deckschicht 35, sofern vorhanden, angeordnet werden.

Optional kann auf der ersten Substratseite 1, zum Beispiel direkt auf der ersten Hauptoberfläche 11 des Substrats 10 oder, sofern vorhanden, auf der elektrisch isolierenden Deckschicht 35, eine Isolatorschicht 34 angeordnet werden, die die Metallisierungsschicht 31 lateral gegenüber weiteren elektrisch leitfähigen Strukturen auf dem Substrat 10 elektrisch isolieren kann. Bei der Isolatorschicht 34 kann es sich beispielsweise um ein planarisiertes Dielektrikum handeln.

Auf der Metallisierungsschicht 31 kann eine weitere Schicht, zum Beispiel eine zweite Metallisierungsschicht 32 angeordnet werden. Auf der zweiten Metallisierungsschicht 32 wiederum kann eine weitere Schicht, zum Beispiel eine dritte Metallisierungsschicht 33 angeordnet werden. Die Metallisierungsschichten 31, 32, 33 können, in jeder Ausführungsform der Erfindung, insbesondere mindestens ein Übergangsmetall aufweisen beziehungsweise als Übergangsmetallschichten ausgestaltet sein.

Wie in Figur 5B zu sehen ist, können die Metallisierungsschichten 31, 32, 33 mittels chemischer Umsetzung, zumindest teilweise, in Verbindungshalbleiter-Schichten 21, 22, 23 umgewandelt werden. Zum Beispiel kann ein dem Substrat 10 abgewandter oberer Abschnitt der ersten Metallisierungsschicht 31, wie zuvor unter Bezugnahme auf Figur 4B beschrieben, mittels chemischer Umsetzung zu der ersten Verbindungshalbleiter-Schicht 21 umgesetzt bzw. umgewandelt werden. Die zweite Metallisierungsschicht 32 kann mittels chemischer Umsetzung ganz oder teilweise zu der zweiten Verbindungshalbleiter-Schicht 22 umgesetzt bzw. umgewandelt werden. Die dritte Metallisierungsschicht 33 kann mittels chemischer Umsetzung ganz oder teilweise zu der dritten Verbindungshalbleiter-Schicht 23 umgesetzt bzw. umgewandelt werden. Die einzelnen Schichten können alle in einem gemeinsamen Schritt chemisch umgewandelt werden, d.h. es werden zuerst alle Metallisierungsschichten 31, 32, 33 übereinander angeordnet und anschließend werden die Metallisierungsschichten 31, 32, 33 gemeinsam chemisch umgewandelt, z.B. durch gleichzeitige Zugabe eines geeigneten Reaktionspartners zur chemischen Umsetzung.

Im Ergebnis entsteht die in Figur 5B abgebildete erfindungsgemäße Halbleiter-Bauelementstruktur 100, die mindestens eine Metallisierungsschicht 31 und eine darauf angeordnete Verbindungshalbleiter-Schicht 21 aufweist.

Die Bereiche der ersten Metallisierungsschicht 31, die auf umliegenden Durchkontaktierungen 13 angeordnet sind, können ebenfalls mittels chemischer Umsetzung ganz oder teilweise zu einer Verbindungshalbleiter-Schicht umgesetzt bzw. umgewandelt werden.

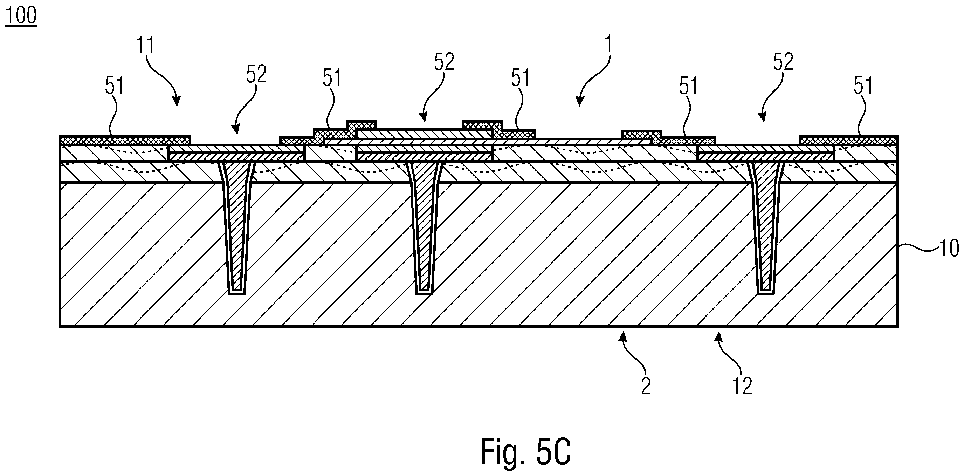

Wie in Figur 5C zu sehen ist, können optional ein oder mehrere Passivierungsschichten 51 auf der ersten Substratseite 1 angeordnet werden. Die Passivierungsschichten 51 können Öffnungen 52 im Bereich der jeweiligen, über den Durchkontaktierungen 13 angeordneten, Schichten 21, 22, 23, 31 aufweisen.

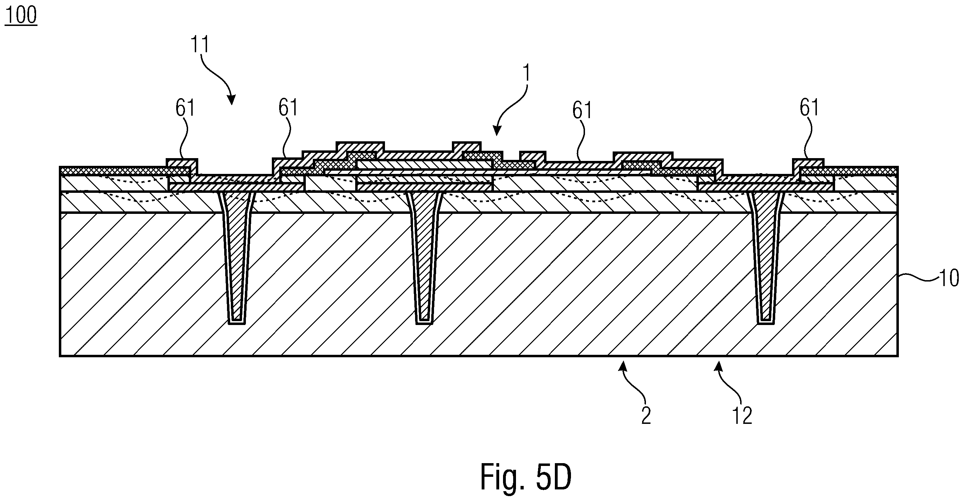

Wie in Figur 5D zu sehen ist, können ein oder mehrere Anschluss-Metallisierungsschichten 61 auf der ersten Substratseite 1, und insbesondere im Bereich der zuvor erwähnten Öffnungen 52, angeordnet werden.

Das Substrat 10 kann außerdem von der Rückseite, d.h. von der zweiten Substratseite 2 bzw. der zweiten Hauptoberfläche 12 her rückgedünnt werden, und zwar soweit bis die vertikalen Durchkontaktierungen 13 freigelegt werden. So kann die abgebildete Halbleiter-Bauelementstruktur 100 in ein 3D-System integriert werden, indem die Verbindungshalbleiter-Schicht 21 über die vertikale Durchkontaktierung 13 mit einer gegenüber der zweiten Hauptoberfläche 12 angeordneten (nicht abgebildeten) zusätzlichen separaten Bauelementstruktur verbunden wird.

Die Halbleiter-Bauelementstruktur 100 kann in der abgebildeten Anordnung eine Transistorstruktur bilden. Die drei übereinander angeordneten Verbindungshalbleiter-Schichten 21, 22, 23 können dabei drei abwechselnde p-n-Übergänge bilden, die die Transistorstruktur realisieren. Je nach Anschluss-Typ kann beispielsweise die erste Verbindungshalbleiter-Schicht 21 eine Emitterschicht des Transistors bereitstellen. Die zweite Verbindungshalbleiter-Schicht 22 kann eine Basis-Schicht des Transistors bereitstellen. Und die dritte Verbindungshalbleiter-Schicht 23 kann eine Kollektorschicht des Transistors bereitstellen. Die Emitterschicht und die Kollektorschicht können auch vertauscht sein. Im Regelfall wird die Emitterschicht eine höhere Ladungsträgerdichte aufweisen als die Basis-Schicht, und die Basis-Schicht wird ihrerseits wiederum eine höhere Ladungsträgerdichte aufweisen als die Kollektorschicht.

Das oben gesagte gilt im Falle der in den Figuren 5A-5D abgebildeten Transistorstruktur mit drei Verbindungshalbleiter-Schichten 21, 22, 23. Sofern die erfindungsgemäße Halbleiter-Bauelementstruktur 100 als eine zwei Verbindungshalbleiter-Schichten 21, 22 aufweisende Diodenstruktur ausgestaltet sein sollte, gilt all das oben gesagte ebenso.

Obwohl die obigen Aspekte im Zusammenhang mit der erfindungsgemäßen Halbleiter-Bauelementstruktur 100 beschrieben wurden, versteht es sich, dass diese Aspekte auch eine Beschreibung des entsprechenden Verfahrens zum Herstellen einer erfindungsgemäßen Halbleiter-Bauelementstruktur 100 darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Nachfolgend soll die Erfindung nochmals in anderen Worten kurz zusammengefasst werden:
Die vorliegende Erfindung betrifft, unter anderem, ein Verfahren zur Herstellung von dreidimensionalen elektronischen Systemen 1000, und insbesondere von dreidimensionalen integrierten Schaltungen. Unter einer dreidimensionalen Integration wird die vertikale Verbindung (mechanisch und elektrisch) von Bauelementen verstanden. Die Vorteile eines dreidimensional integrierten elektronischen Systems 1000 sind u. a. die erreichbaren höheren Packungsdichten und Schaltgeschwindigkeiten (bedingt durch kürzere Leitungswege) gegenüber zweidimensionalen Systemen (Planartechnik).

Die erfindungsgemäße Halbleiter-Bauelementstruktur 100 realisiert eine kürzest-mögliche Verbindung innerhalb eines 3D-Systems 1000 zwischen einkristallinem (2D)-Halbleitermaterial und elektrischem Kontakt zum nächsten Subsystem 101. Dies kann insbesondere vorteilhaft sein für den vertikalen Aufbau von elektronischen Bauelementen mit minimalem Footprint und minimaler Leistungsaufnahme für Neuromorphe Netze, zum Beispiel für einen 3D-Systemaufbau für verlustleistungsarme neuronale Netze.

Hierfür wird erfindungsgemäß vorgeschlagen, eine elektrisch isolierte Durchkontaktierung 13 durch das Substrat 10 (through substrate via; TSV) zu erzeugen, die in direktem Kontakt mit der halbleitenden Struktur 21 steht. Das TSV 13 kann zuerst erzeugt werden. Die halbleitende Schicht 21 kann entweder auf dem TSV 13 abgeschieden und strukturiert oder durch eine direkte chemische Reaktion lokal erzeugt werden. Mittels weiterer Abscheidungen oder chemischen Umsetzungen entstehen so komplexere Halbleiter-Bauelemente, die mindestens ein TSV 13 beinhalten. Zwischen dem TSV-Metall und den halbleitenden Schichten 21, 22, 23 des Bauelements 100 können andere Metalle oder halbleitende Schichten als Pufferschichten zur Anpassung des Kontaktwiderstandes eingebracht sein. Dies bietet eine kürzest-mögliche Verbindung zwischen Halbleiter 21 und TSV 13 sowie dem Ziel-Chip des 3D-Systems 1000.

Ausführungsformen der Erfindung bilden einen mikroelektronischen Anschluss mit Substrat-Durchkontaktierung 13 und Verbindungshalbleiter-Struktur 21.

Gemäß einem Aspekt der Erfindung wird ein Verfahren zum Verbinden von mindestens zwei elektrischen Komponenten vorgeschlagen, mit den folgenden Schritten:
Bereitstellen eines Substrates 10,
Erzeugen eines gegenüber dem Substrat 10 elektrisch isolierten leitenden Kanals 13 durch das Substrat 10,
Erzeugen eines Kontaktelementes 31 welches mit dem leitenden Kanal 13 elektrisch leitend verbunden ist,
Erzeugen einer ersten Verbindungshalbleiter-Schicht 21, die mit dem Kontaktelement 31 elektrisch leitend verbunden ist,
Erzeugen einer zweiten Verbindungshalbleiter-Schicht 22, die mit der ersten Verbindungshalbleiter-Schicht 21 elektrisch leitend verbunden ist, und
Erzeugen einer dritten Verbindungshalbleiter-Schicht 23, die mit der zweiten Verbindungshalbleiter-Schicht 22 elektrisch leitend verbunden ist.

Gemäß einem weiteren Aspekt wird mindestens eine der Verbindungshalbleiter-Schichten 21, 22, 23 durch Abscheidung erzeugt.

Gemäß einem weiteren Aspekt wird mindestens eine der Verbindungshalbleiter-Schichten 21, 22, 23 lokal durch chemische Reaktion erzeugt.

Die Figuren 5A-5D zeigen eine Schichtfolge und einen Ablauf zur Herstellung von TSV 13 im Kontakt mit halbleitender Schichtung 21 am Beispiel von lokaler chemischer Umsetzung zur Herstellung einer Transistorstruktur.

Ferner wird eine, im Folgenden auch als mikroelektronische Anschlussvorrichtung bezeichnete Halbleiter-Bauelementstruktur 100, vorgeschlagen, aufweisend:
ein Substrat 10,
ein gegenüber dem Substrat 10 elektrisch isolierter leitender Kanal 13 durch das Substrat 10,
ein Kontaktelement 31 welches mit dem leitenden Kanal 13 elektrisch leitend verbunden ist,
eine erste Verbindungshalbleiter-Schicht 21, die mit dem Kontaktelement 31 elektrisch leitend verbunden ist,
eine zweite Verbindungshalbleiter-Schicht 22, die mit der ersten Verbindungshalbleiter-Schicht 21 elektrisch leitend verbunden ist, und
eine dritte Verbindungshalbleiter-Schicht 23, die mit der zweiten Verbindungshalbleiter-Schicht 22 elektrisch leitend verbunden ist.

Die vorliegende Erfindung kann ferner in Form der folgenden Ausführungsbeispiele realisierbar sein:
1. Halbleiter-Bauelementstruktur (100), aufweisend:
   ein Substrat (10) mit einer auf einer ersten Substratseite (1) gelegenen ersten Hauptoberfläche (11) und einer auf einer gegenüberliegenden zweiten Substratseite (2) gelegenen zweiten Hauptoberfläche (12),
   eine vertikale Durchkontaktierung (13), die sich zwischen der ersten Hauptoberfläche (11) und der zweiten Hauptoberfläche (12) vollständig durch das Substrat (10) hindurch erstreckt,
   eine auf der ersten Substratseite (1) im Bereich der Durchkontaktierung (13) angeordnete Metallisierungsschicht (31), die galvanisch mit der Durchkontaktierung (13) verbunden ist, und
   eine auf der Metallisierungsschicht (31) angeordnete und mit der Metallisierungsschicht (31) galvanisch verbundene Verbindungshalbleiter-Schicht (21).
2. Halbleiter-Bauelementstruktur (100) nach Ausführungsbeispiel 1,
   wobei die Verbindungshalbleiter-Schicht (21) einen monokristallinen Verbindungs-Halbleiter aufweist.
3. Halbleiter-Bauelementstruktur (100) nach Ausführungsbeispiel 1 oder 2,
   wobei die Verbindungshalbleiter-Schicht (21) mindestens ein 2D-Verbundmaterial aufweist.
4. Halbleiter-Bauelementstruktur (100) nach einem der vorhergehenden Ausführungsbeispiele,
   wobei die Verbindungshalbleiter-Schicht (21) eine Elementkombination aus der Gruppe der Übergangsmetalle und der Gruppe der Chalkogeniden aufweist.
5. Halbleiter-Bauelementstruktur (100) nach einem der vorhergehenden Ausführungsbeispiele,
   wobei die Metallisierungsschicht (31) direkt auf der ersten Hauptoberfläche (11) des Substrats (10) angeordnet ist, oder
   wobei auf der ersten Substratseite (1) eine elektrisch isolierende Schicht (35) zwischen der ersten Hauptoberfläche (11) des Substrats (10) und der Metallisierungsschicht (31) angeordnet ist.
6. Halbleiter-Bauelementstruktur (100) nach einem der vorhergehenden Ausführungsbeispiele,
   wobei die Verbindungshalbleiter-Schicht (21) mittels Abscheidung auf der Metallisierungsschicht (31) angeordnet ist.
7. Halbleiter-Bauelementstruktur (100) nach einem der Ausführungsbeispiele 1 bis 5,
   wobei die Verbindungshalbleiter-Schicht (21) mittels chemischer Umsetzung aus zumindest einem Teil der Metallisierungsschicht (31) gebildet ist.
8. Halbleiter-Bauelementstruktur (100) nach einem der vorhergehenden Ausführungsbeispiele,
   ferner aufweisend eine auf der Verbindungshalbleiter-Schicht (21) angeordnete und mit der Verbindungshalbleiter-Schicht (21) galvanisch verbundene zweite Verbindungshalbleiter-Schicht (22).
9. Halbleiter-Bauelementstruktur (100) nach Ausführungsbeispiel 8,
   wobei die zweite Verbindungshalbleiter-Schicht (22) mindestens ein 2D-Verbundmaterial aufweist.
10. Halbleiter-Bauelementstruktur (100) nach Ausführungsbeispiel 8 oder 9,
   ferner aufweisend eine auf der zweiten Verbindungshalbleiter-Schicht (22) angeordnete und mit der zweiten Verbindungshalbleiter-Schicht (22) galvanisch verbundene dritte Verbindungshalbleiter-Schicht (23).
11. Halbleiter-Bauelementstruktur (100) nach Ausführungsbeispiel 10,
   wobei die dritte Verbindungshalbleiter-Schicht (23) mindestens ein 2D-Verbundmaterial aufweist.
12. Halbleiter-Bauelementstruktur (100) nach einem der vorhergehenden Ausführungsbeispiele,
   wobei auf der ersten und/oder der zweiten Substratseite (1, 2) ein galvanisch mit der vertikalen Durchkontaktierung (13) verbundener Kontaktierungsabschnitt (110) angeordnet ist, und
   wobei die Halbleiter-Bauelementstruktur (100) mittels diesem Kontaktierungsabschnitt (110) galvanisch und/oder mechanisch mit einer zusätzlichen separaten elektronischen Bauelementstruktur (101) verbindbar ist, um ein dreidimensionales elektronisches Halbleiter-Bauelement (1000) zu erzeugen, bei dem die Halbleiter-Bauelementstruktur (100) und die zusätzliche separate elektronische Bauelementstruktur (101) vertikal übereinander angeordnet sind.
13. Dreidimensionales elektronisches Halbleiter-Bauelement (1000) mit mindestens einer Halbleiter-Bauelementstruktur (100) gemäß einem der vorhergehenden Ausführungsbeispiele,
   wobei die Halbleiter-Bauelementstruktur (100) mittels der vertikalen Durchkontaktierung (13) galvanisch und/oder mechanisch mit einer zusätzlichen separaten elektronischen Bauelementstruktur (101) verbunden ist, und
   wobei die Halbleiter-Bauelementstruktur (100) und die zusätzliche separate elektronische Bauelementstruktur (101) vertikal übereinander angeordnet sind.
14. Verfahren zum Herstellen einer Halbleiter-Bauelementstruktur (100), wobei das Verfahren die folgenden Schritte aufweist:
   Bereitstellen eines Substrats (10) mit einer auf einer ersten Substratseite (1) gelegenen ersten Hauptoberfläche (11) und einer auf einer gegenüberliegenden zweiten Substratseite (2) gelegenen zweiten Hauptoberfläche (12),
   Strukturieren einer vertikalen Durchkontaktierung (13), die sich zwischen der ersten Hauptoberfläche (11) und der zweiten Hauptoberfläche (12) vollständig durch das Substrat (10) hindurch erstreckt,
   Anordnen einer Metallisierungsschicht (31) auf der ersten Substratseite (1) im Bereich der Durchkontaktierung (13), sodass die Metallisierungsschicht (31) galvanisch mit der Durchkontaktierung (13) verbunden ist, und
   Anordnen einer Verbindungshalbleiter-Schicht (21) auf der Metallisierungsschicht (31), sodass die Verbindungshalbleiter-Schicht (21) galvanisch mit der Metallisierungsschicht (31) verbunden ist.
15. Verfahren nach Ausführungsbeispiel 14,
   wobei der Schritt des Anordnens der Verbindungshalbleiter-Schicht (21) beinhaltet, dass ein monokristalliner Verbindungs-Halbleiter auf der Metallisierungsschicht (31) angeordnet wird.
16. Verfahren nach Ausführungsbeispiel 14 oder 15,
   wobei der Schritt des Anordnens der Verbindungshalbleiter-Schicht (21) beinhaltet, dass mindestens ein 2D-Verbundmaterial auf der Metallisierungsschicht (31) angeordnet wird.
17. Verfahren nach einem der Ausführungsbeispiele 14 bis 16,
   wobei der Schritt des Anordnens der Verbindungshalbleiter-Schicht (21) beinhaltet, dass mindestens eine Elementkombination aus der Gruppe der Übergangsmetalle und der Gruppe der Chalkogeniden auf der Metallisierungsschicht (31) angeordnet wird.
18. Verfahren nach einem der Ausführungsbeispiele 14 bis 17,
   wobei die Metallisierungsschicht (31) direkt auf der ersten Hauptoberfläche (11) des Substrats (10) angeordnet wird, oder
   wobei auf der ersten Substratseite (1) eine elektrisch isolierende Schicht (35) zwischen der ersten Hauptoberfläche (11) des Substrats (10) und der Metallisierungsschicht (31) angeordnet wird.
19. Verfahren nach einem der Ausführungsbeispiele 14 bis 18,
   wobei der Schritt des Anordnens der Verbindungshalbleiter-Schicht (21) beinhaltet, dass die Verbindungshalbleiter-Schicht (21) unter Anwendung eines Abscheideverfahrens auf der Metallisierungsschicht (31) abgeschieden wird.
20. Verfahren nach einem der Ausführungsbeispiele 14 bis 18,
   wobei der Schritt des Anordnens der Verbindungshalbleiter-Schicht (21) beinhaltet, dass die Verbindungshalbleiter-Schicht (21) mittels chemischer Umsetzung aus zumindest einem Teil der Metallisierungsschicht (31) gebildet wird.
21. Verfahren nach einem der Ausführungsbeispiele 14 bis 20,
   wobei auf der Verbindungshalbleiter-Schicht (21) eine zweite Verbindungshalbleiter-Schicht (22) angeordnet und mit der Verbindungshalbleiter-Schicht (21) galvanisch verbunden wird.
22. Verfahren nach Ausführungsbeispiel 21,
   wobei die zweite Verbindungshalbleiter-Schicht (22) mindestens ein 2D-Verbundmaterial aufweist.
23. Verfahren nach Ausführungsbeispiel 21 oder 22,
   wobei auf der zweiten Verbindungshalbleiter-Schicht (22) eine dritte Verbindungshalbleiter-Schicht (23) angeordnet und mit der zweiten Verbindungshalbleiter-Schicht (22) galvanisch verbunden wird.
24. Verfahren nach Ausführungsbeispiel 23,
   wobei die dritte Verbindungshalbleiter-Schicht (23) mindestens ein 2D-Verbundmaterial aufweist.
25. Verfahren nach einem der vorhergehenden Ausführungsbeispiele, ferner aufweisend
   Anordnen eines Kontaktierungsabschnitts (110) auf der zweiten Hauptoberfläche (12) des Substrats (10), sodass der Kontaktierungsabschnitt (110) galvanisch mit der vertikalen Durchkontaktierung (13) verbunden ist, und
   galvanisches Verbinden der Halbleiter-Bauelementstruktur (100) mit einer zusätzlichen separaten elektronischen Bauelementstruktur (101) mittels diesem Kontaktierungsabschnitt (110), um ein dreidimensionales elektronisches HalbleiterBauelement zu erzeugen, wobei die zusätzliche separate elektronische Bauelementstruktur (101) der zweiten Hauptoberfläche (12) des Substrats (10) gegenüberliegend angeordnet ist.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Halbleiter-Bauelementstruktur (100), aufweisend:
ein Substrat (10) mit einer auf einer ersten Substratseite (1) gelegenen ersten Hauptoberfläche (11) und einer auf einer gegenüberliegenden zweiten Substratseite (2) gelegenen zweiten Hauptoberfläche (12), wobei auf der ersten Hauptoberfläche (11) ein planarer Schichtstapel angeordnet ist,
eine vertikale Durchkontaktierung (13), die sich zwischen der ersten Hauptoberfläche (11) und der zweiten Hauptoberfläche (12) vollständig durch das Substrat (10) hindurch erstreckt,
wobei der planare Schichtstapel aufweist:
eine auf der ersten Substratseite (1) im Bereich der Durchkontaktierung (13) angeordnete Metallisierungsschicht (31), die galvanisch mit der Durchkontaktierung (13) verbunden ist, und
eine auf der Metallisierungsschicht (31) angeordnete und mit der Metallisierungsschicht (31) galvanisch verbundene Verbindungshalbleiter-Schicht (21).

2. Halbleiter-Bauelementstruktur (100) nach Anspruch 1,
wobei die Verbindungshalbleiter-Schicht (21) einen monokristallinen Verbindungs-Halbleiter aufweist, und/oder
wobei die Verbindungshalbleiter-Schicht (21) eine Elementkombination aus der Gruppe der Übergangsmetalle und der Gruppe der Chalkogeniden aufweist.

3. Halbleiter-Bauelementstruktur (100) nach einem der vorhergehenden Ansprüche,
wobei die Metallisierungsschicht (31) direkt auf der ersten Hauptoberfläche (11) des Substrats (10) angeordnet ist, oder
wobei auf der ersten Substratseite (1) eine elektrisch isolierende Schicht (35) zwischen der ersten Hauptoberfläche (11) des Substrats (10) und der Metallisierungsschicht (31) angeordnet ist.

4. Halbleiter-Bauelementstruktur (100) nach einem der vorhergehenden Ansprüche,
wobei die Verbindungshalbleiter-Schicht (21) mittels Abscheidung auf der Metallisierungsschicht (31) angeordnet ist, oder
wobei die Verbindungshalbleiter-Schicht (21) mittels chemischer Umsetzung aus zumindest einem Teil der Metallisierungsschicht (31) gebildet ist.

5. Halbleiter-Bauelementstruktur (100) nach einem der vorhergehenden Ansprüche,
wobei der Schichtstapel ferner eine auf der Verbindungshalbleiter-Schicht (21) angeordnete und mit der Verbindungshalbleiter-Schicht (21) galvanisch verbundene zweite Verbindungshalbleiter-Schicht (22) aufweist.

6. Halbleiter-Bauelementstruktur (100) nach Anspruch 5,
wobei der Schichtstapel ferner eine auf der zweiten Verbindungshalbleiter-Schicht (22) angeordnete und mit der zweiten Verbindungshalbleiter-Schicht (22) galvanisch verbundene dritte Verbindungshalbleiter-Schicht (23) aufweist.

7. Halbleiter-Bauelementstruktur (100) nach einem der vorhergehenden Ansprüche,
wobei die Verbindungshalbleiter-Schicht (21) und/oder die zweite Verbindungshalbleiter-Schicht (22) und/oder die dritte Verbindungshalbleiter-Schicht (23) mindestens ein 2D-Verbundmaterial aufweist.

8. Halbleiter-Bauelementstruktur (100) nach einem der vorhergehenden Ansprüche,
wobei auf der ersten und/oder der zweiten Substratseite (1, 2) ein galvanisch mit der vertikalen Durchkontaktierung (13) verbundener Kontaktierungsabschnitt (110) angeordnet ist, und
wobei die Halbleiter-Bauelementstruktur (100) mittels diesem Kontaktierungsabschnitt (110) galvanisch und/oder mechanisch mit einer zusätzlichen separaten elektronischen Bauelementstruktur (101) verbindbar ist, um ein dreidimensionales elektronisches Halbleiter-Bauelement (1000) zu erzeugen, bei dem die Halbleiter-Bauelementstruktur (100) und die zusätzliche separate elektronische Bauelementstruktur (101) vertikal übereinander angeordnet sind.

9. Halbleiter-Bauelementstruktur (100) nach einem der vorhergehenden Ansprüche, wobei der Schichtstapel ein planares 2D-Bauelement bildet.

10. Dreidimensionales elektronisches Halbleiter-Bauelement (1000) mit mindestens einer Halbleiter-Bauelementstruktur (100) gemäß einem der vorhergehenden Ansprüche,
wobei die Halbleiter-Bauelementstruktur (100) mittels der vertikalen Durchkontaktierung (13) galvanisch und/oder mechanisch mit einer zusätzlichen separaten elektronischen Bauelementstruktur (101) verbunden ist, und
wobei die Halbleiter-Bauelementstruktur (100) und die zusätzliche separate elektronische Bauelementstruktur (101) vertikal übereinander angeordnet sind.

11. Verfahren zum Herstellen einer Halbleiter-Bauelementstruktur (100), wobei das Verfahren die folgenden Schritte aufweist:
Bereitstellen eines Substrats (10) mit einer auf einer ersten Substratseite (1) gelegenen ersten Hauptoberfläche (11) und einer auf einer gegenüberliegenden zweiten Substratseite (2) gelegenen zweiten Hauptoberfläche (12),
Anordnen eines planaren Schichtstapels auf der ersten Hauptoberfläche (11) des Substrats (10),
Strukturieren einer vertikalen Durchkontaktierung (13), die sich zwischen der ersten Hauptoberfläche (11) und der zweiten Hauptoberfläche (12) vollständig durch das Substrat (10) hindurch erstreckt,
wobei der Schritt des Anordnens des planaren Schichtstapels beinhaltet:
Anordnen einer Metallisierungsschicht (31) auf der ersten Substratseite (1) im Bereich der Durchkontaktierung (13), sodass die Metallisierungsschicht (31) galvanisch mit der Durchkontaktierung (13) verbunden ist, und
Anordnen einer Verbindungshalbleiter-Schicht (21) auf der Metallisierungsschicht (31), sodass die Verbindungshalbleiter-Schicht (21) galvanisch mit der Metallisierungsschicht (31) verbunden ist.

12. Verfahren nach Anspruch 11,
wobei der Schritt des Anordnens der Verbindungshalbleiter-Schicht (21) beinhaltet, dass ein monokristalliner Verbindungs-Halbleiter auf der Metallisierungsschicht (31) angeordnet wird, oder
wobei der Schritt des Anordnens der Verbindungshalbleiter-Schicht (21) beinhaltet, dass mindestens eine Elementkombination aus der Gruppe der Übergangsmetalle und der Gruppe der Chalkogeniden auf der Metallisierungsschicht (31) angeordnet wird.

13. Verfahren nach einem der Ansprüche 11 oder 12,
wobei der Schritt des Anordnens der Verbindungshalbleiter-Schicht (21) beinhaltet, dass die Verbindungshalbleiter-Schicht (21) unter Anwendung eines Abscheideverfahrens auf der Metallisierungsschicht (31) abgeschieden wird, oder
wobei der Schritt des Anordnens der Verbindungshalbleiter-Schicht (21) beinhaltet, dass die Verbindungshalbleiter-Schicht (21) mittels chemischer Umsetzung aus zumindest einem Teil der Metallisierungsschicht (31) gebildet wird.

14. Verfahren nach einem der Ansprüche 11 bis 13,
wobei der Schritt des Anordnens des planaren Schichtstapels beinhaltet, dass auf der Verbindungshalbleiter-Schicht (21) eine zweite Verbindungshalbleiter-Schicht (22) angeordnet und mit der Verbindungshalbleiter-Schicht (21) galvanisch verbunden wird.

15. Verfahren nach Anspruch 14,
wobei der Schritt des Anordnens des planaren Schichtstapels beinhaltet, dass auf der zweiten Verbindungshalbleiter-Schicht (22) eine dritte Verbindungshalbleiter-Schicht (23) angeordnet und mit der zweiten Verbindungshalbleiter-Schicht (22) galvanisch verbunden wird.
